# EUROPEAN PATENT APPLICATION

(11) **EP 3 534 409 A1**
(43) Date of publication of application: **04.09.2019**
(21) Application number: 17863379.8
(22) Date of filing: 31.10.2017
(51) Int. Cl.: H01L 31/042, H01L 31/043, H01L 31/048

(54) **SOLAR CELL MODULE**

(30) Priority: 31.10.2016 JP 2016212581
(71) Applicant: Kyocera Corporation, Kyoto-shi Kyoto 612-8501 (JP)
(72) Inventor: ARANAMI, Junji, Kyoto-shi Kyoto 612-8501 (JP); MIYAMICHI, Yusuke, Kyoto-shi Kyoto 612-8501 (JP); SANO, Hirotaka, Kyoto-shi Kyoto 612-8501 (JP); TAKAHASHI, Eigo, Kyoto-shi Kyoto 612-8501 (JP); OGURI, Seiji, Kyoto-shi Kyoto 612-8501 (JP)
(74) Representative: Viering, Jentschura & Partner mbB Patent- und Rechtsanwälte
(86) International application number: PCT/JP2017/039268
(87) International publication number: WO 2018/079811

(57) **Abstract**

A solar cell module includes a first plate part, a second plate part, a solar cell section, and a plurality of wiring materials. The first plate part has a first face, and a second face positioned in a state of facing directions opposite to each other. The second plate part has a third face positioned in a state of being opposed to the second face, and a fourth face positioned in a state of facing a direction opposite to the third face. The solar cell section is positioned in a gap between the first plate part and the second plate part. The plurality of wiring materials are positioned in a state of being electrically connected to the solar cell section. At least one of the first plate part and the second plate part has a light-transmitting property for light having a wavelength in a specific range. At least one wiring material of the plurality of wiring materials is positioned from the inside of the gap to the outside of the gap, along a cutout part that is cut out in a part along one side of the second plate part with the first plate part as a reference, in plan view of the second plate part.

## Description

### Technical Field

The present disclosure relates to a solar cell module.

### Background Art

There are solar cell modules that have a structure in which a plurality of solar cells are sandwiched between two glass plates (for example, see the description in Japanese Patent No. 5702472). Moreover, there are ones in which a lead wire for extraction of electric power generated in a plurality of solar cells extends to the outside through a through hole of one glass plate (for example, see the description in Japanese Patent No. 5702472).

### Summary

A solar cell module is disclosed.

One aspect of the solar cell module includes a first plate part, a second plate part, a solar cell section, and a plurality of wiring materials. The first plate part has a first face, and a second face positioned in a state of facing a direction opposite to the first face. The second plate part has a third face positioned in a state of being opposed to the second face, and a fourth face positioned in a state of facing a direction opposite to the third face. The solar cell section is positioned in a gap between the first plate part and the second plate part. The plurality of wiring materials are positioned in a state of being electrically connected to the solar cell section. At least one of the first plate part and the second plate part has a light-transmitting property for light having a wavelength in a specific range. At least one wiring material of the plurality of wiring materials is positioned from the inside of the gap to the outside of the gap, along a cutout part that is cut out in a part along one side of the second plate part with the first plate part as a reference in plan view of the second plate part.

One aspect of the solar cell module includes a first plate part, a second plate part, and a solar cell section. The first plate part has a first face, and a second face positioned in a state of facing a direction opposite to the first face. The second plate part has a third face positioned in a state of being opposed to the second face, and a fourth face positioned in a state of facing a direction opposite to the third face. The solar cell section is positioned in a gap between the first plate part and the second plate part. At least one of the first plate part and the second plate part has a light-transmitting property for light having a wavelength in a specific range. The solar cell section includes a first photoelectric conversion part, and a second photoelectric conversion part positioned in a state of being aligned with the first photoelectric conversion part in a thickness direction of the first plate part. The first photoelectric conversion part includes a plurality of first solar cell elements positioned in a state of being aligned in a first direction along the second face and being electrically connected in series. The second photoelectric conversion part includes a plurality of solar cell element groups positioned in a state of being aligned along the first direction. The plurality of solar cell element groups each include a plurality of second solar cell elements positioned in a state of being aligned along the third face in a second direction crossing the first direction and electrically connected in series. The plurality of solar cell element groups include a first solar cell element group and a second solar cell element group positioned in a state of being electrically connected in series, and a third solar cell element group positioned in a state of being electrically connected in series with the second solar cell element group. The plurality of second solar cell elements included in the first solar cell element group include a 2A-th solar cell element connected to the second solar cell element group by a wiring material, and a 2B-th solar cell element positioned on a side opposite to the 2A-th solar cell element in the second direction. The plurality of second solar cell elements included in the third solar cell element group include a 2C-th solar cell element connected to the second solar cell element group by a wiring material, and a 2D-th solar cell element positioned on a side opposite to the 2C-th solar cell element in the second direction. A wiring material positioned in a state of being connected to the 2B-th solar cell element and a wiring material connected to the 2C-th solar cell element are in a state of being electrically connected via a bypass diode.

### Brief Description of Drawings

Fig. 1(a) is a perspective view showing an appearance of an example of a solar cell module. Fig. 1(b) is a plan view showing an appearance of a back surface side of an example of the solar cell module.
Fig. 2 is an enlarged perspective view showing a configuration of a part of the solar cell module, in a portion A1 of Fig. 1(a).
Fig. 3 is a cross-sectional view showing a cross section of the solar cell module taken along line III-III of Fig. 1(a).
Fig. 4 is an enlarged cross-sectional view showing a configuration of a part of the solar cell module, in a portion A2 of Fig. 3.
Fig. 5 is an end view showing a configuration of an example of a solar cell module with a frame corresponding to a cross section of the solar cell module taken along line III-III of Fig. 1(a).
Fig. 6 is a flowchart of a flow according to one example of a method for manufacturing the solar cell module.
Figs. 7(a) to 7(e) are cross-sectional views individually illustrating a state in middle of manufacturing the solar cell module.
Fig. 8 is a cross-sectional view showing a configuration of an example of a solar cell module according to a second embodiment, corresponding to a cross section of the solar cell module taken along line III-III of Fig. 1(a).
Fig. 9 is a plan view showing a configuration of an example of a protected part according to a third embodiment.
Fig. 10 is an end view showing a cross section of the protected part taken along line X-X of Fig. 9.
Fig. 11 is a plan view showing a configuration of an example of a protected part according to one reference example.
Fig. 12 is a cross-sectional view showing a configuration of an example of a solar cell module according to a fourth embodiment.
Fig. 13 is a plan view showing a configuration of an example of a first photoelectric conversion part and a first wiring material.
Fig. 14 is a plan view showing a configuration of an example of a second photoelectric conversion part and a second wiring material.
Fig. 15 is a plan view showing a configuration of an example of a solar cell section having a tandem structure according to one reference example.
Fig. 16 is a perspective view schematically showing a state of forming a laminate at a time of manufacturing a solar cell module.
Fig. 17 is a cross-sectional view showing a configuration of an example of the laminate.
Fig. 18 is a plan view showing a configuration of a second photoelectric conversion part, a wiring material, and the like according to a modified example of the fourth embodiment.
Figs. 19(a) and 19(b) are views showing a usage mode of a solar cell module according to a modified example of the fourth embodiment. Fig. 19(a) is a view showing a usage mode of a first photoelectric conversion part according to a modified example of the fourth embodiment. Fig. 19(b) is a view showing a usage mode of a second photoelectric conversion part according to a modified example of the fourth embodiment.
Figs. 20(a) and 20(b) are views showing a usage mode of a solar cell module according to one reference example. Fig. 20(a) is a view showing a usage mode of a first photoelectric conversion part according to one reference example. Fig. 20(b) is a view showing a usage mode of a second photoelectric conversion part according to one reference example.
Fig. 21 is a plan view showing a configuration of a first photoelectric conversion part according to a modified example of the fourth embodiment.
Fig. 22 is a cross-sectional view showing a configuration of a part of a protected part according to a fifth embodiment.
Fig. 23 is a cross-sectional view showing a configuration of a part of a protected part according to a sixth embodiment.
Fig. 24 is a perspective view showing an appearance of one example of a solar cell module according to a seventh embodiment.
Fig. 25 is a plan view showing an appearance on a back surface side of one example of a solar cell module according to the seventh embodiment.
Fig. 26 is an enlarged plan view showing a configuration of a part of the solar cell module, in a portion XXVI of Fig. 25.

### Description of Embodiments

There are solar cell modules that have a structure in which, for example, a plurality of solar cells are sandwiched between two glass plates. With such a configuration, for example, moisture is unlikely to enter the inside of the solar cell module from either a front face or a back surface of the solar cell module, and deterioration of the plurality of solar cells is unlikely to occur.

Meanwhile, in a solar cell module, for example, it is necessary to arrange a wiring for extraction of electric power generated by photoelectric conversion in a plurality of solar cells so as to be drawn out from inside to outside the solar cell module.

Here, for example, it is conceivable that the wiring is inserted through a through hole of one glass plate. However, in this case, for example, there is a risk that moisture easily enters the inside of the solar cell module through the through hole of the glass plate.

Further, for example, it is also conceivable to arrange the wiring so as to be drawn out to the outside from an outer peripheral part of a gap between the two glass plates. However, in this case, for example, it is not easy to cover the wiring drawn out from the outer peripheral part of the gap of the glass plates with some member, and there is a risk that the wiring is easily exposed to outside air. For this reason, for example, there is a risk that the wiring is likely to deteriorate. Further, for example, if a moisture-proof sheet or the like to cover the wiring is added, there is a risk that the manufacturing cost of the solar cell module is increased due to an increase of a consumption of resources according to an increase in the number of members.

Further, for example, it is conceivable to shift the two glass plates from each other such that an end part of the glass plate on the front face side protrudes from an end part of the glass plate on the back surface side, and to draw out the wiring to the outside from a gap between the two glass plates, in a portion where the end parts of the two glass plates are shifted. In this case, for example, it is conceivable to bond a terminal box to the back surface of the glass plate on the front face side so as to cover the wiring, in a portion where the end parts of the two glass plates are shifted.

However, in this case, for example, in a portion where the end part of the glass plate on the front face side protrudes from the end part of the glass plate on the back surface side, it is assumed that a frame or a stand to hold an outer peripheral part of the solar cell module is mounted to only one glass plate on the front face side. At this time, for example, there is a risk that the strength of the solar cell module deteriorates. Further, there is a risk that, for example, in plan perspective view of the solar cell module from a front surface side, a proportion of an area of a region where the solar cell can be arranged with respect to an area of the front surface of the solar cell module is reduced in accordance with the shift between the two glass plates. At this time, there is a risk that, for example, an area (also referred to as an effective area) of a front face on which light contributing to power generation is incident on the surface of the solar cell module is reduced. In other words, there is a risk that a conversion efficiency indicating a ratio of being converted into electric energy in energy of light incident on the solar cell module decreases.

Meanwhile, for example, it is conceivable to reduce entry of moisture from a side face part of the solar cell module toward the inside of the solar cell module by sufficiently arranging a sealing material excellent in a water barrier property, such as butyl rubber, on the outer peripheral part of the gap between two glass plates,

However, in this case, for example, paying attention to reducing entry of moisture toward the inside of the solar cell module, a region where the solar cell is arranged is to be reduced if a region arranged with the sealing material excellent in a water barrier property is increased. For this reason, there is a risk that, on a surface of the solar cell module, an area (the effective area) of a surface on which light contributing to power generation is incident is reduced. In other words, there is a risk that the conversion efficiency in the solar cell module decreases.

Therefore, the inventors of the present application have created a technique capable of easily maintaining high conversion efficiency in a solar cell module for a long period of time.

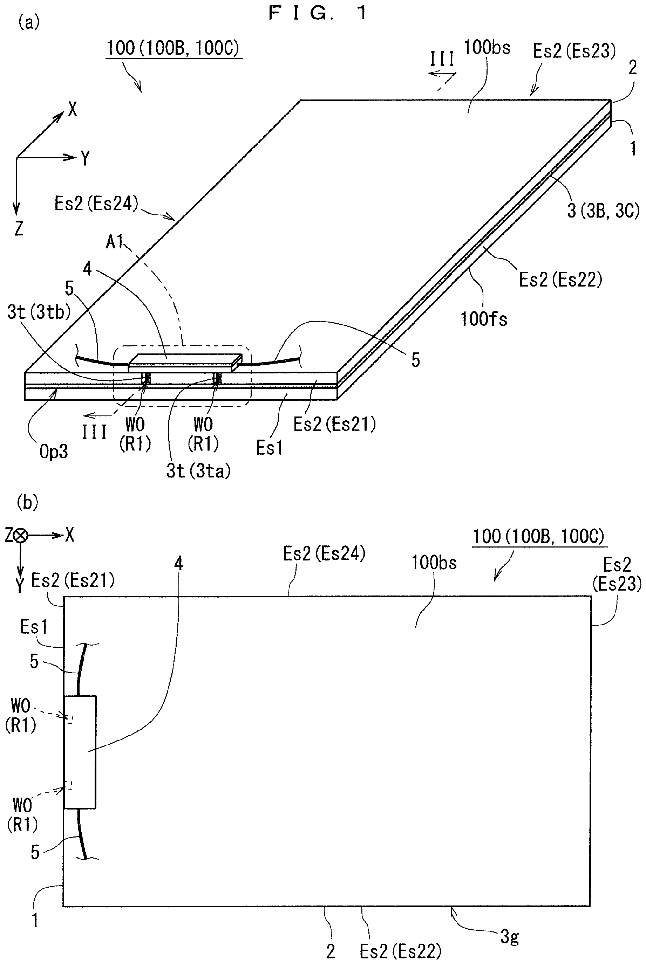

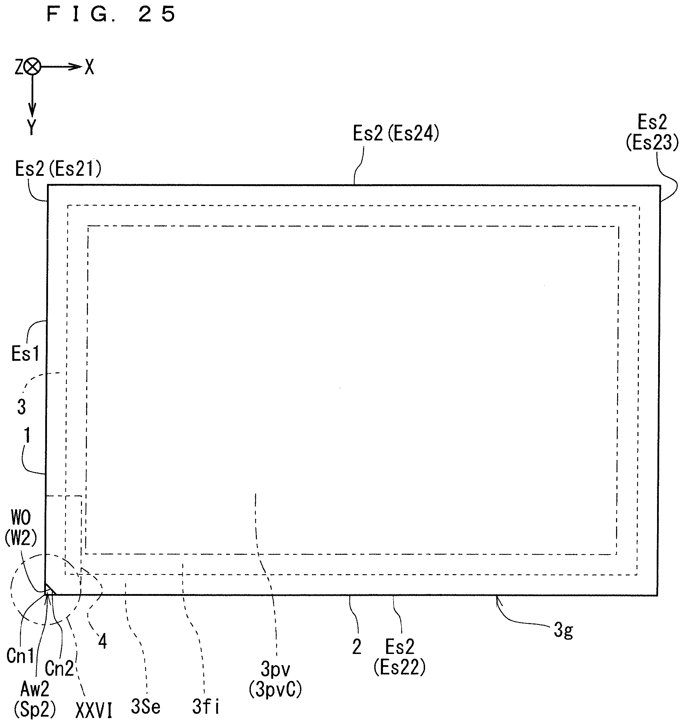

Regarding this, various embodiments will be described with reference to the drawings below. In the drawings, the same reference numerals are given to portions having similar configurations and functions, and redundant explanations are omitted in the following description. Further, the drawings are schematically shown. In Figs. 1(a) to 5 and Figs. 7(a) to 26, a right-handed XYZ coordinate system is given. In this XYZ coordinate system, a direction along a long side of a solar cell modules 100, 100B, 100C, and 100F is defined as a +X direction, a direction along a short side of the solar cell modules 100, 100B, 100C, and 100F is defined as a +Y direction, and a direction orthogonal to both the +X direction and the +Y direction is defined as a +Z direction.

### <1. First Embodiment>

### <1-1. Configuration of Solar Cell Module>

A configuration of a solar cell module 100 according to a first embodiment will be described with reference to Figs. 1(a) to 4. As shown in Figs. 1(a) to 4, the solar cell module 100 includes a first plate part 1, a second plate part 2, a protected part 3, a terminal box 4, and an output wiring 5. In the first embodiment, a surface of the first plate part 1 on the +Z direction side is defined as a surface (also referred to as a front surface) 100fs that is mainly irradiated with external light such as sunlight. Further, a surface of the second plate part 2 on a -Z direction side is defined as a surface (also referred to as a back surface) 100bs that is irradiated with less external light such as sunlight than the front surface 100fs.

The first plate part 1 has a first face 1a, and a second face 1b facing in a direction opposite to this first face 1a. In the examples of Figs. 1(a) to 4, the first face 1a faces in the +Z direction and the second face 1b faces in the -Z direction. A shape of the first plate part 1 is, for example, a flat plate shape. Specifically, for example, a flat plate having the first face 1a and the second face 1b of a rectangular shape such as an oblong is adopted as the first plate part 1. The first plate part 1 is positioned on the +Z direction side of the protected part 3. This allows, for example, the first plate part 1 to protect the protected part 3.

The first plate part 1 has, for example, a light-transmitting property for light having a wavelength in a specific range. Therefore, for example, light irradiated on the front surface 100fs and transmitted through the first plate part 1 can be incident on the protected part 3, and can be used for photoelectric conversion in the solar cell section 3pv included in the protected part 3.

For example, when glass or a resin such as acrylic or polycarbonate having a thickness of about 1 mm to 5 mm is adopted as the first plate part 1, the first plate part 1 having a water barrier property is realized. This can reduce entry of moisture from the outside of the solar cell module 100 to the protected part 3. At this time, for example, the first plate part 1 having a light-transmitting property for light having a wavelength in the specific range can also be realized. As a wavelength in the specific range, for example, there is adopted a wavelength of light that may be photoelectrically converted by the solar cell section 3pv in the protected part 3. When a wavelength of light having a high irradiation intensity constituting sunlight is included in the wavelength in the specific range, photoelectric conversion efficiency in the solar cell module 100 can be improved.

The second plate part 2 has a third face 2a, and a fourth face 2b facing in a direction opposite to this third face 2a. In the examples of Figs. 1(a) to 4, the third face 2a faces in the +Z direction and the fourth face 2b faces in the -Z direction. The third face 2a is positioned so as to be opposed to the second face 1b of the first plate part 1. Then, the protected part 3 is positioned in a gap 3g between the first plate part 1 and the second plate part 2. Therefore, the second plate part 2 can protect the protected part 3 together with the first plate part 1. A distance that the first plate part 1 and the second plate part 2 are separated from each other with the gap 3g interposed in between is, for example, about 0.5 mm to 5 mm. A shape of the second plate part 2 is, for example, a flat plate shape similar to that of the first plate part 1. Specifically, for example, a flat plate having the third face 2a and the fourth face 2b of a rectangular shape such as an oblong is adopted as the second plate part 2. For example, the second plate part 2 may have a light-transmitting property for light having a wavelength in the specific range, or may not have a light-transmitting property for light having a wavelength in the specific range.

For example, when glass or a resin such as acrylic or polycarbonate having a thickness of about 1 mm to 5 mm is adopted as the second plate part 2, the second plate part 2 having a water barrier property is realized. This can reduce entry of moisture from the outside of the solar cell module 100 to the protected part 3. At this time, for example, the second plate part 2 having a light-transmitting property for light having a wavelength in the specific range may also be realized. This allows, for example, light irradiated to the back surface 100bs and transmitted through the second plate part 2 to be incident on the protected part 3, and to be used for photoelectric conversion in the solar cell section 3pv in the protected part 3. As a result, for example, an output in the solar cell module 100 can be improved. Light to be incident on the back surface 100bs may be generated, for example, by reflection of sunlight on the ground or the like. Further, as a material of the second plate part 2, for example, ceramics or the like not having a light-transmitting property for light having a wavelength in the specific range may be adopted.

The second plate part 2 includes a side face part Es2 positioned so as to connect the third face 2a and the fourth face 2b. In the example of Figs. 1(a) to 4, the side face part Es2 includes a first side face part Es21, a second side face part Es22, a third side face part Es23, and a fourth side face part Es24. Specifically, the first side face part Es21 is positioned in a state of facing in the -X direction. The second side face part Es22 is positioned in a state of facing in the +Y direction. The third side face part Es23 is positioned in a state of facing the +X direction. The fourth side face part Es24 is positioned in a state of facing the -Y direction.

As shown in Fig. 1(a) and Fig. 1(b), the side face part Es2 of the second plate part 2 includes a cutout part W0. The cutout part W0 is a portion that is cut out with the first plate part 1 as a reference, in a part along at least one side of the second plate part 2 in plan view of the second plate part 2. In the example of Figs. 1(a) to 4, the side face part Es2 includes a recess part R1 as an example of the cutout part W0. The recess part R1 is positioned in a state of being recessed in a direction along the third face 2a. From another viewpoint, the recess part R1 is positioned on at least one side of the second plate part 2 in plan view of the second plate part 2. In addition, the recess part R1 has an opening (also referred to as a first opening) Op1 on the third face 2a side and an opening (also referred to as a second opening) Op2 on the fourth face 2b side. In other words, the recess part R1 penetrates the second plate part 2 from the third face 2a to the fourth face 2b. This recess part R1 is for arranging a wiring material 3t capable of outputting electric charges obtained by photoelectric conversion in the solar cell section 3pv to the outside of the solar cell module 100.

In the example of Figs. 1(a) to 4, two recess parts R1 are positioned on the first side face part Es21. Each recess part R1 is positioned in a state of being recessed in the +X direction along the third face 2a. Further, the recess part R1 is positioned in a state of penetrating the second plate part 2 from the third face 2a to the fourth face 2b, along the +Z direction as a thickness direction of the second plate part 2. At this time, the recess part R1 has a first opening Op1 positioned on the +Z direction side as the third face 2a side, and a second opening Op2 positioned on the -Z direction side as the fourth face 2b side. As a shape of a cross section perpendicular to the +Z direction of the recess part R1, for example, a substantially rectangular shape is adopted. In this case, for example, even if a shape of a cross section perpendicular to a longitudinal direction of the wiring material 3t is rectangular or circular, it is easy to arrange the wiring material 3t inside the recess part R1. A width of the recess part R1 (here, a width in the +Y direction) is set to, for example, several mm to 10 mm. A depth of the recess part R1 (here, a depth in the +X direction) is set to, for example, about 1 mm to 5 mm. The recess part R1 may be formed by a tool such as a grinder, or jet water flow or the like. In the first embodiment, the second plate part 2 has the same outer shape as the first plate part 1 except for the presence of the recess part R1.

The protected part 3 includes the solar cell section 3pv, a plurality of wiring materials 3t, a first sealing material 3fi, and a second sealing material 3se. Therefore, the solar cell section 3pv is positioned in the gap 3g between the first plate part 1 and the second plate part 2. The solar cell section 3pv may be positioned, for example, in a state of being in direct contact with the first plate part 1 or the second plate part 2, or may be positioned in a state of being sandwiched between the first plate part 1 and the second plate part 2.

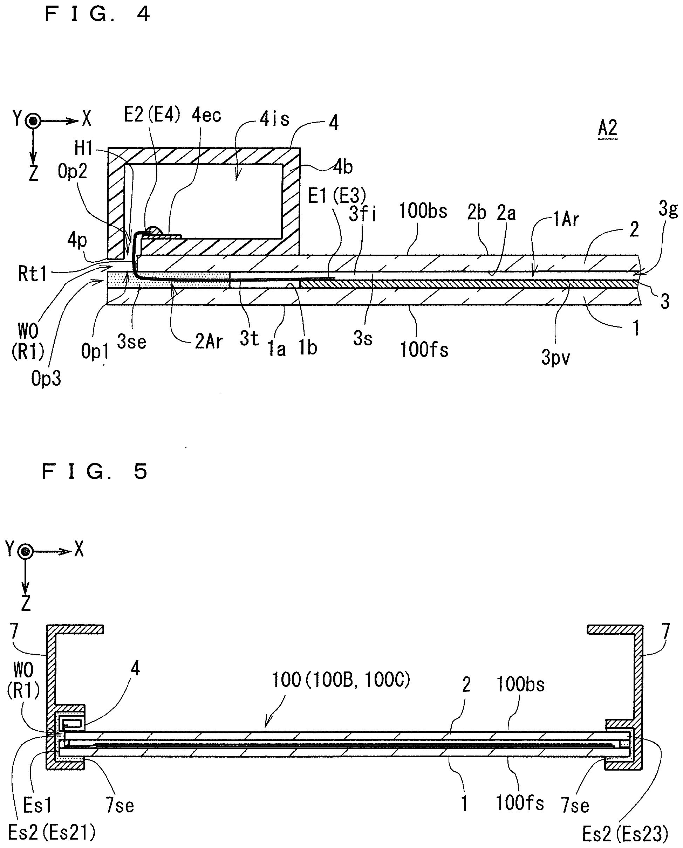

The solar cell section 3pv includes a portion (also referred to as a photoelectric conversion part) capable of performing photoelectric conversion for converting incident sunlight into electricity. For example, it suffices that one or more types of photoelectric conversion parts are included in the solar cell section 3pv. The photoelectric conversion part includes, for example, N pieces of (N is a natural number) solar cell element capable of converting incident sunlight into electricity. As the solar cell element, for example, a solar cell element (also referred to as a crystalline solar cell element) using a semiconductor of crystal type (also referred to as a crystalline semiconductor), a solar cell element (also referred to as a thin film solar cell element) using a semiconductor of a thin film type (also referred to as a thin film semiconductor), a solar cell (also referred to as a dye sensitized solar cell) using at least one of an organic dye and an inorganic dye, or the like can be adopted. As the crystalline semiconductor, for example, there may be adopted a silicon semiconductor such as monocrystalline silicon, polycrystalline silicon, or a heterojunction type, or a compound semiconductor such as III-V group. Further, as the thin film semiconductor, for example, a semiconductor of silicon based, compound based, or other type may be adopted. As the silicon thin film semiconductor, for example, a semiconductor using amorphous silicon, thin polycrystalline silicon, or the like is applied. As the compound thin film semiconductor, for example, a compound semiconductor having a chalcopyrite structure such as a CIS semiconductor or a CIGS semiconductor, a compound semiconductor such as a compound having a perovskite structure, a compound semiconductor having a kesterite structure, or cadmium telluride (CdTe) semiconductor is applied. The CIS semiconductor is a compound semiconductor containing copper (Cu), indium (In), and selenium (Se). The CIGS semiconductor is a compound semiconductor containing copper (Cu), indium (In), gallium (Ga), and selenium (Se). Here, for example, in a case where N pieces of solar cell element are electrically connected in series, an output of the solar cell module 100 may be larger as N is larger. In the example of Fig. 4, there is formed the solar cell section 3pv including a plurality of thin film solar cell elements on the first plate part 1.

The plurality of wiring materials 3t are positioned in a state of being electrically connected to the solar cell section 3pv. For example, the plurality of wiring materials 3t include a positive electrode wiring material 3ta and a negative electrode wiring material 3tb. The wiring material 3t is positioned in a state of extending along the recess part R1 as an example of the cutout part W0, from the inside of the gap 3g to the outside of the gap 3g. Specifically, the wiring material 3t is positioned in a state of extending from the inside of the gap 3g to the outside of the gap 3g so as to pass through a path Rt1 that is from the first opening Op1 to the second opening Op2 in a space (also referred to as a cutout space) positioned inside the recess part R1 as an example of the cutout part W0. From another viewpoint, the wiring material 3t is positioned from the inside of the gap 3g via the recess part R1, to a region that is on a side (the -Z direction side in the example of Figs. 1(a) to 4) opposite to a region where there is the first plate part 1 with a virtual surface including the fourth face 2b and the second opening Op2 as a reference.

In the examples of Figs. 1(a) to 4, one end part (also referred to as a first end part) E1 in a longitudinal direction of the positive electrode wiring material 3ta is positioned in a state of being electrically connected to a positive electrode of the solar cell section 3pv. The other end part (also referred to as a second end part) E2 in the longitudinal direction of the positive electrode wiring material 3ta is positioned on a side opposite to the first plate part 1 with the second plate part 2 as a reference. Further, one end part (also referred to as a third end part) E3 in a longitudinal direction of the negative electrode wiring material 3tb is positioned in a state of being electrically connected to a negative electrode of the solar cell section 3pv. The other end part (also referred to as a fourth end part) E4 in the longitudinal direction of the negative electrode wiring material 3tb is positioned on a side opposite to the first plate part 1 with the second plate part 2 as a reference.

Here, as described above, the wiring material 3t is positioned so as to pass through the cutout space inside the recess part R1 of the side face part Es2 of the second plate part 2, from the gap 3g. Therefore, for example, without shifting a side face part Es1 of the first plate part 1 and the side face part Es2 of the second plate part 2, the wiring material 3t can be arranged from the gap 3g to a region on a side opposite to the gap 3g with the second plate part 2 interposed in between. This allows, for example, a frame 7 (Fig. 5) or a stand to hold a portion of the solar cell module 100 along one side including the recess part R1 from which the wiring material 3t is drawn out from the inside of the gap 3g to the outside of the gap 3g, so as to sandwich the first plate part 1 and the second plate part 2. As a result, for example, the strength of the solar cell module 100 is unlikely to deteriorate.

Further, for example, without shifting the side face part Es1 of the first plate part 1 and the side face part Es2 of the second plate part 2 in order to form a region where the terminal box 4 is arranged on the second face 1b, the wiring material 3t can be arranged from the gap 3g to a region on a side opposite to the gap 3g with the second plate part 2 interposed in between. Therefore, for example, the terminal box 4 can be arranged immediately above a region required for sealing at the end part of the gap 3g between the first plate part 1 and the second plate part 2. This makes it difficult for the effective area of the solar cell module 100 to decrease. As a result, for example, the conversion efficiency of the solar cell module 100 is unlikely to deteriorate.

Further, for example, without providing a through hole for insertion of the wiring material 3t through the second plate part 2, the wiring material 3t can be arranged to a region on a side opposite to the gap 3g with the second plate part 2 interposed in between. As a result, for example, entry of moisture from the outside of the solar cell module 100 toward the solar cell section 3pv is reduced. Further, for example, as compared with the case of simply providing a through hole in the second plate part 2, the recess part R1 can be positioned in the frame 7, and deterioration of the strength of the solar cell module 100 can be reduced.

Therefore, for example, with regard to the solar cell module 100, it is possible to easily maintain high conversion efficiency for a long period of time.

As the wiring material 3t, for example, one having a belt-like shape may be adopted. As a material of the wiring material 3t, for example, a metal or the like having conductivity, such as copper or aluminum, may be adopted. Here, for example, as the wiring material 3t, there may be adopted one having a belt shape with a thickness of about 0.1 mm to 0.5 mm and a width of about 2 mm to 5 mm. For example, in a case where the width of the wiring material 3t is several mm, for example, when the width of the recess part R1 is about 5 mm or more, it is possible to easily perform alignment of the wiring material 3t with respect to the recess part R1. Further, for example, when solder is coated on the entire surface of the wiring material 3t, the wiring material 3t can be easily joined to the solar cell section 3pv or the like. The wiring material 3t is positioned in a state of being electrically connected to the solar cell section 3pv, for example, by joining by soldering.

The first sealing material 3fi is in a state of being filled in a first region 1Ar covering at least the solar cell section 3pv, in the gap 3g between the first plate part 1 and the second plate part 2. As the first region 1Ar, for example, there may be adopted such a region that covers the entire surface of the second plate part 2 side (the -Z direction side) of the solar cell section 3pv positioned on the second face 1b of the first plate part 1. The first sealing material 3fi can seal the solar cell section 3pv by covering the solar cell section 3pv. Further, by filling the first sealing material 3fi in the gap 3g over a wide range of the gap 3g, moisture and the like are unlikely to enter the solar cell section 3pv. As a material of the first sealing material 3fi, for example, there may be adopted an ethylene-vinyl acetate copolymer (EVA), triacetyl cellulose (TAC), or a polyester resin such as polyethylene naphthalate or the like, having an excellent light-transmitting property for light having a wavelength in the specific range. For example, the first sealing material 3fi may be made of two or more kinds of sealing materials.

In the gap 3g between the first plate part 1 and the second plate part 2, the second sealing material 3se is in a state of being closer to an opening (also referred to as a third opening) Op3 of the gap 3g than the first region 1Ar, and filled in a region (also referred to as a second region) 2Ar along this third opening Op3. The third opening Op3 is positioned at an outer peripheral edge of the gap 3g. In the example of Figs. 1(a) to 4, the third opening Op3 is an annular opening that is present between the side face part Es1 of the first plate part 1 and the side face part Es2 of the second plate part 2. Then, the second region 2Ar is an annular region along the annular third opening Op3. From another viewpoint, for example, in plan perspective view of the solar cell module 100 in a thickness direction (+Z direction) of the first plate part 1, the second region 2Ar is positioned in a state of surrounding the first region 1Ar. In this way, for example, in the second region 2Ar, since the region from the first plate part 1 to the second plate part 2 is in a state of being filled with the second sealing material 3se, a state is realized where the second region 2Ar is filled with the second sealing material 3se. The second sealing material 3se has a higher water barrier property than that of the first sealing material 3fi. Therefore, for example, the annular third opening Op3 of the gap 3g between the first plate part 1 and the second plate part 2 is positioned in a state of being sealed with the second sealing material 3se. This may reduce entry of moisture or the like from the outside of the solar cell module 100 via the annular third opening Op3 toward the solar cell section 3pv. As a result, long-term reliability of the solar cell module 100 can be enhanced. As a material of the second sealing material 3se, for example, a butyl resin, a polyisopropylene resin, acrylic resin, or the like may be adopted.

The terminal box 4 is positioned in a state of being positioned so as to cover at least a part of the second opening Op2 of the recess part R1, on the fourth face 2b as the back surface 100bs on a side opposite to the first plate part 1, on the second plate part 2. The terminal box 4 is what is called a so-called junction box. In the examples of Figs. 1(a) to 4, one terminal box 4 is positioned in a state of being positioned for the two recess parts R1. For example, the wiring material 3t is positioned in a state of being present to extend to an inside 4is of the terminal box 4 via a through hole H1 of the terminal box 4, from a portion covered with the terminal box 4, in the second opening Op2. Here, for example, it suffices that the wiring material 3t is positioned so as to pass through a portion where the second opening part Op2 and the through hole H1 communicate with each other. Then, the wiring material 3t is positioned, for example, in a state of being electrically connected to a terminal component 4ec in the inside 4is of the terminal box 4. Here, for example, the second end part E2 of the positive electrode wiring material 3ta is positioned in a state of being electrically connected to one terminal component 4ec in the inside 4is of the terminal box 4. Further, the fourth end part E4 of the negative electrode wiring material 3tb is positioned in a state of being electrically connected to another terminal component 4ec in the inside 4is of the terminal box 4.

Here, for example, when the wiring material 3t is positioned from the gap 3g between the first plate part 1 and the second plate part 2 so as to reach the inside of the terminal box 4 immediately after passing through the recess part R1, for example, the wiring material 3t is unlikely to be exposed to outside air, and the wiring material 3t is unlikely to deteriorate. As a result, for example, it is possible to reduce an increase in the number of special members such as a moisture-proof sheet to cover the wiring material 3t, and to reduce an increase in manufacturing cost of the solar cell module 100 due to an increase of a consumption of resources. Therefore, for example, in the solar cell module 100, it is possible to easily maintain high conversion efficiency for a long period of time.

Further, the terminal box 4 is positioned in a state of being fixed to the back surface 100bs. The terminal box 4 may be in a state of being fixed to the back surface 100bs with use of resin such as silicon sealant, for example. Here, for example, the terminal box 4 is positioned so as to cover the recess part R1 from the back surface 100bs side. At this time, for example, when the terminal box 4 includes a resin casing 4b with a high water barrier property, and a portion between this casing 4b and the back surface 100bs is in a state of being closed by resin or the like, passage of moisture or the like from the outside of the solar cell module 100 toward the second opening Op2 of the recess part R1 may be reduced.

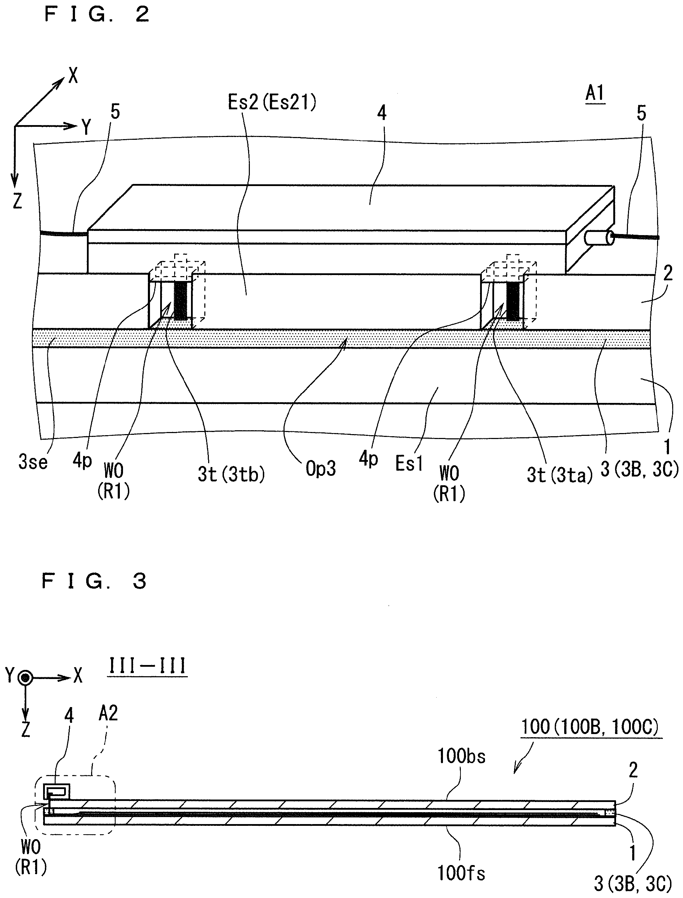

Further, in the examples of Figs. 2 and 4, for example, the terminal box 4 includes a protrusion 4p fitted into the recess part R1. When there is such a protrusion 4p, positional alignment of the terminal box 4 can be performed easily by fitting the protrusion 4p into the recess part R1, for example, at a time of mounting the terminal box 4 to the back surface 100bs.

The output wiring 5 can output electricity obtained through the solar cell module 100 to the outside. For example, the output wiring 5 is positioned in a state of being electrically connected to the wiring material 3t via the terminal component 4ec, in the inside 4is of the terminal box 4. Then, the output wiring 5 is present in a state of extending from the inside 4is of the terminal box 4 to the outside of the terminal box 4. In the example of Fig. 1(a), the output wiring 5 is positioned in a state of extending along a direction (±Y direction) along the first side face part Es21 from the terminal box 4.

Further, as shown in Fig. 5, the frame 7 made of, for example, aluminum or the like may be in a state of being mounted to a first end face Es21, a second end face Es22, a third end face Es23, and a fourth end face Es24 of the solar cell module 100. In the example of Fig. 5, the frame 7 is in a state of being mounted so as to sandwich the first plate part 1, the second plate part 2, and the terminal box 4 at an end part on the -X direction side of the solar cell module 100. Further, at this time, when a sealing material (also referred to as an outer sealing material) 7se is in a state of being filled between the frame 7, and the first end face Es21, the second end face Es22, the third end face Es23, and the fourth end face Es24, entry of moisture or the like into the solar cell section 3pv from the first end face Es21, the second end face Es22, the third end face Es23, and the fourth end face Es24 of the solar cell module 100 may be reduced. As a result, long-term reliability of the solar cell module 100 may be enhanced. Further, at this time, for example, when the outer sealing material 7se is positioned so as to cover the wiring material 3t in the space (cutout space) inside the recess part R1 as an example of the cutout part W0, the wiring material 3t is in a state of being sealed in the cutout space inside the recess part R1. This makes it difficult, for example, for the wiring material 3t to be exposed to outside air, and for the wiring material 3t to deteriorate. Therefore, for example, in the solar cell module 100, it is possible to easily maintain high conversion efficiency for a long period of time. As a material of the outer sealing material 7se, for example, a butyl resin, a polyisopropylene resin, acrylic resin, or the like may be adopted. Here, for example, when a large number of outer sealing materials 7se are adhered in a molten or semi-molten state by heating in a portion opposed to the recess part R1 of the frame 7 in advance at a time of mounting the frame 7 to the solar cell module 100, the outer sealing material 7se may be filled in the cutout space inside the recess part R1. Further, for example, before mounting the frame 7 to the solar cell module 100, the outer sealing material 7se molten or semi-molten by heating may be filled in the cutout space inside the recess part R1. In this case, even in a case of adopting a configuration in which the frame 7 is not mounted to the solar cell module 100, high conversion efficiency in the solar cell module 100 can easily be maintained for a long period of time.

### <1-2. Manufacturing Method for Solar Cell Module>

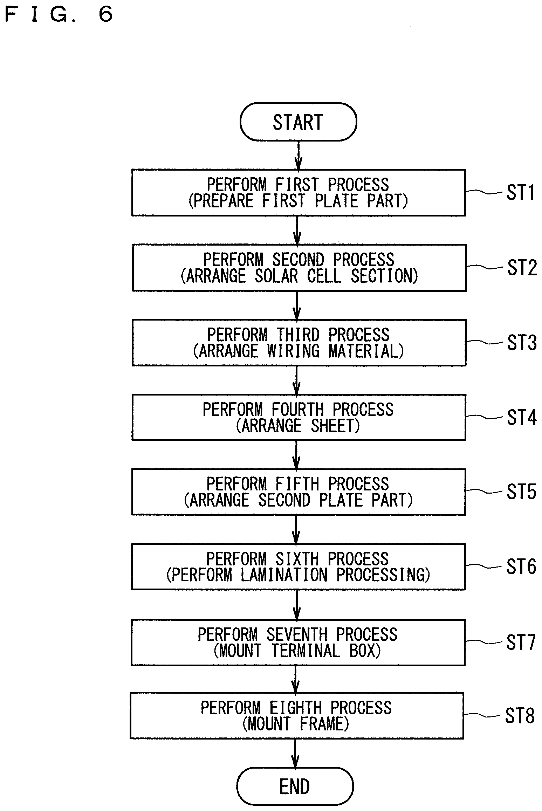

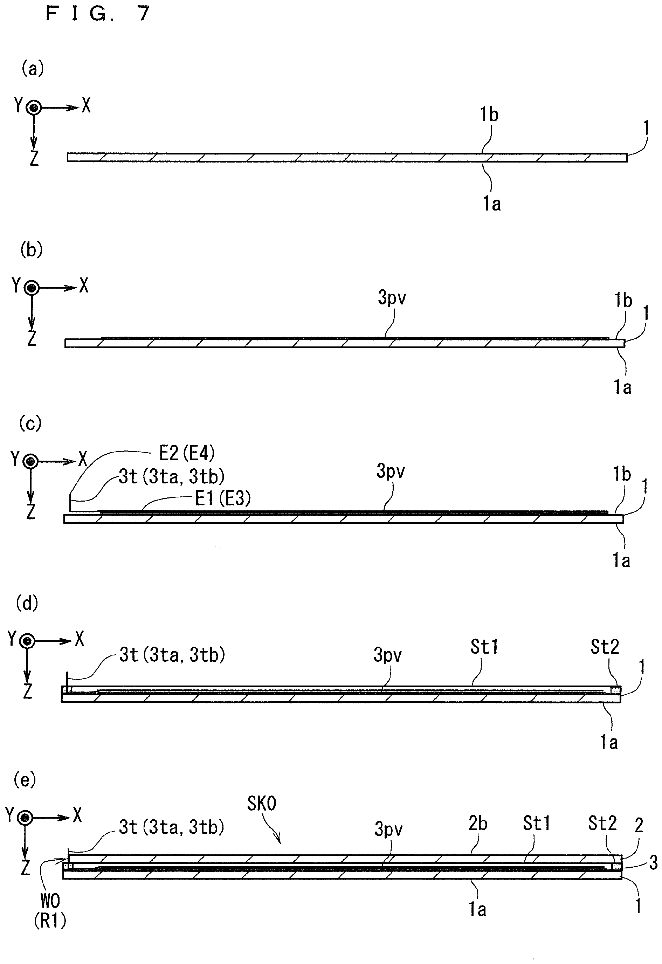

One example of a method for manufacturing the solar cell module 100 will be described with reference to Figs. 6 and 7. Here, the solar cell module 100 can be manufactured by performing a first process to an eighth process of steps ST1 to ST8 shown in Fig. 6 in this described order.

In step ST1, the first process of preparing the first plate part 1 is performed. Here, for example, as shown in Fig. 7(a), a flat-plate-shaped glass plate or the like having the first face 1a and the second face 1b with a rectangular shape is prepared as the first plate part 1.

Next, in step ST2, the second process of arranging the solar cell section 3pv is performed. Here, for example, as shown in Fig. 7(b), the solar cell section 3pv is arranged on the second face 1b of the first plate part 1. At this time, for example, a thin film photoelectric conversion element or the like as the solar cell section 3pv may be formed on the second face 1b of the first plate part 1 with the first plate part 1 as a substrate, or the solar cell section 3pv including one or more already manufactured photoelectric conversion elements may be placed on the second face 1b of the first plate part 1. For example, an aspect may be considered in which there is formed the solar cell section 3pv in which a plurality of thin film solar cell elements are connected in series on the second face 1b of the first plate part 1.

Next, in step ST3, the third process of arranging the wiring material 3t is performed. Here, for example, as shown in Fig. 7(c), the first end part E1 of the positive electrode wiring material 3ta and the third end part E3 of the negative electrode wiring material 3tb are electrically connected to the solar cell section 3pv. At this time, for example, the first end part E1 of the positive electrode wiring material 3ta is joined to the positive electrode of the solar cell section 3pv, and the third end part E3 of the negative electrode wiring material 3tb is joined to the negative electrode of the solar cell section 3pv. Joining of the wiring material 3t to the solar cell section 3pv is performed by, for example, soldering or the like. In addition, here, the wiring material 3t may be arranged along a desired path by being bent appropriately. Here, the wiring material 3t may be bent at a desired position, for example, before being joined to the solar cell section 3pv. For example, for connection to the terminal box 4, a portion on the second end part E2 side of the wiring material 3t is bent in the -Z direction. At this time, for example, a portion of the wiring material 3t arranged along the second face 1b of the first plate part 1 may be joined to the second face 1b by ultrasonic soldering or the like.

Next, in step ST4, the fourth process of arranging a sheet that is to be a sealing material is performed. Here, for example, as shown in Fig. 7(d), a sheet (also referred to as a first sheet) St1 made of a resin (such as EVA) to be the first sealing material 3fi is arranged in a region that is positioned so as to cover the solar cell section 3pv. Further, at this time, on an annular portion along an outer edge part of the second face 1b of the first plate part 1, an annular sheet (also referred to as a second sheet) St2 made of a resin (butyl resin or the like) to be the second sealing material 3se is arranged. At this time, for example, the second sheet St2 is arranged so as to maintain a state where a portion on the second end part E2 side of the wiring material 3t is bent in the -Z direction. Here, for example, the second sheet St2 may be formed by directly applying a resin to be the second sealing material 3se that is brought into a molten or semi-molten state by heating, onto the annular portion along an outer edge part of the first plate part 1.

Next, in step ST5, the fifth process of arranging the second plate part 2 is performed. Here, for example, as shown in Fig. 7(e), the second plate part 2 formed in advance with the recess part R1 as the cutout part W0 is stacked on the first sheet St1 and the second sheet St2. At this time, the wiring material 3t is in a state of being inserted through each of two recess parts R1 in the -Z direction. Here, for example, as the second plate part 2, there is used a flat-plate-shaped glass plate or the like having a third face 2a and a fourth face 2b with a rectangular shape, and including two recess parts R1 in the first side face part Es21. This allows formation of a laminate SK0 in which two wiring materials 3t are arranged, and the first plate part 1, the solar cell section 3pv, the first sheet St1 and the second sheet St2, and the second plate part 2 are stacked.

Next, in step ST6, the sixth process of performing lamination processing on the laminate SK0 is performed. Here, a laminating apparatus (laminator) is used to integrate the laminate SK0. For example, in the laminator, the laminate SK0 is placed on a heater board in a chamber, and the laminate SK0 is heated from about 100°C to 200°C while the inside of the chamber is decompressed from about 50 Pa to about 150 Pa. At this time, the first sheet St1 and the second sheet St2 are brought into a state of being flowable by heating. In this state, the laminate SK0 is pressed by a diaphragm sheet or the like in the chamber, so that the laminate SK0 is brought into a state of being integrated. This causes a state where the solar cell section 3pv is covered with the first sealing material 3fi, and the second sealing material 3se is filled in the annular second region 2Ar closer to the third opening Op3 than the first region 1Ar filled with the first sealing material 3fi. In this lamination processing, for example, integration of the laminate SK0 is performed under reduced pressure. Therefore, for example, air bubbles are unlikely to enter each of the first sheet St1 and the second sheet St2 in the molten state. As a result, pressing of the first sheet St1 and the second sheet St2 in the molten state allows the first sealing material 3fi and the second sealing material 3se to be in a dense state with few vacancies. As a result, for example, a water barrier property by the first sealing material 3fi and the second sealing material 3se may be improved.

Next, in step ST7, the seventh process of mounting the terminal box 4 is performed. Here, for example, as shown in Fig. 3, the terminal box 4 is mounted on the fourth face 2b of the second plate part 2, in the laminate SK0 integrated in the step ST6. At this time, for example, the terminal box 4 is arranged so as to cover the second opening Op2 of the recess part R1. At this time, for example, after the wiring material 3t is connected to the terminal component 4ec in the terminal box 4, a resin such as silicone sealant is used to fix the terminal box 4 to the fourth face 2b of the second plate part 2. Specifically, for example, the second end part E2 of the positive electrode wiring material 3ta is connected to one terminal component 4ec in the terminal box 4, and the fourth end part E4 of the negative electrode wiring material 3tb is connected to another terminal component 4ec in the terminal box 4. Further, at this time, for example, by fitting the protrusion 4p of the terminal box 4 into the recess part R1, positional alignment of the terminal box 4 with the fourth face 2b of the second plate part 2 is performed easily. Further, at this time, the output wiring 5 may be connected to the terminal box 4 in advance, or may be connected to the terminal box 4 later. As described above, the solar cell module 100 is manufactured.

Next, in step ST8, the eighth process of mounting the frame 7 to the solar cell module 100 is performed. Here, for example, as shown in Fig. 5, the frame 7 is mounted to the solar cell module 100 such that the frame 7 made of aluminum is positioned along four sides of the end face of the solar cell module 100. At this time, for example, the outer sealing material 7se excellent in a water barrier property, such as a butyl type resin, is filled between the end face of the solar cell module 100 and the frame 7. Then, for example, the outer sealing material 7se is filled in the cutout space inside the recess part R1 of the second plate part 2. In this way, the solar cell module 100 mounted with the frame 7 is completed.

### <1-3. Summary of First Embodiment>

In the solar cell module 100 according to the first embodiment, for example, the wiring material 3t is positioned so as to be inserted through the space (cutout space) inside the recess part R1 that is present from the gap 3g between the first plate part 1 and the second plate part 2 to the side face part Es2 of the second plate part 2. Therefore, for example, without shifting an end part of the first plate part 1 and an end part of the second plate part 2, the wiring material 3t can be arranged from the gap 3g to a region on a side opposite to the gap 3g with the second plate part 2 interposed in between. This allows, for example, the frame 7 or a stand to be in a state of holding a portion of the solar cell module 100 along an end part including the recess part R1 from which the wiring material 3t is drawn out from the inside of the gap 3g to the outside of the gap 3g, so as to sandwich the first plate part 1 and the second plate part 2. As a result, for example, the strength of the solar cell module 100 becomes unlikely to deteriorate. Further, for example, without shifting the end part of the first plate part 1 and the end part of the second plate part 2 in order to form a region where the terminal box 4 is arranged on the second face 1b opposed to the second plate part 2 of the first plate part 1, the wiring material 3t can be positioned from the gap 3g to a region on a side opposite to the gap 3g with the second plate part 2 interposed in between. This makes it difficult for the effective area of the solar cell module 100 to decrease. As a result, for example, the conversion efficiency of the solar cell module 100 is unlikely to deteriorate. Further, for example, without providing a through hole for insertion of the wiring material 3t through the second plate part 2, the wiring material 3t can be arranged from the gap 3g to the region on a side opposite to the gap 3g with the second plate part 2 interposed in between. As a result, for example, entry of moisture from the outside of the solar cell module 100 toward the solar cell section 3pv is reduced. Therefore, with regard to the solar cell module 100, it is possible to easily maintain high conversion efficiency for a long period of time.

### <2. Other Embodiments>

The present disclosure is not limited to the above-described first embodiment, and various modifications and improvements are possible without departing from the subject matter of the present disclosure.

### <2-1. Second Embodiment>

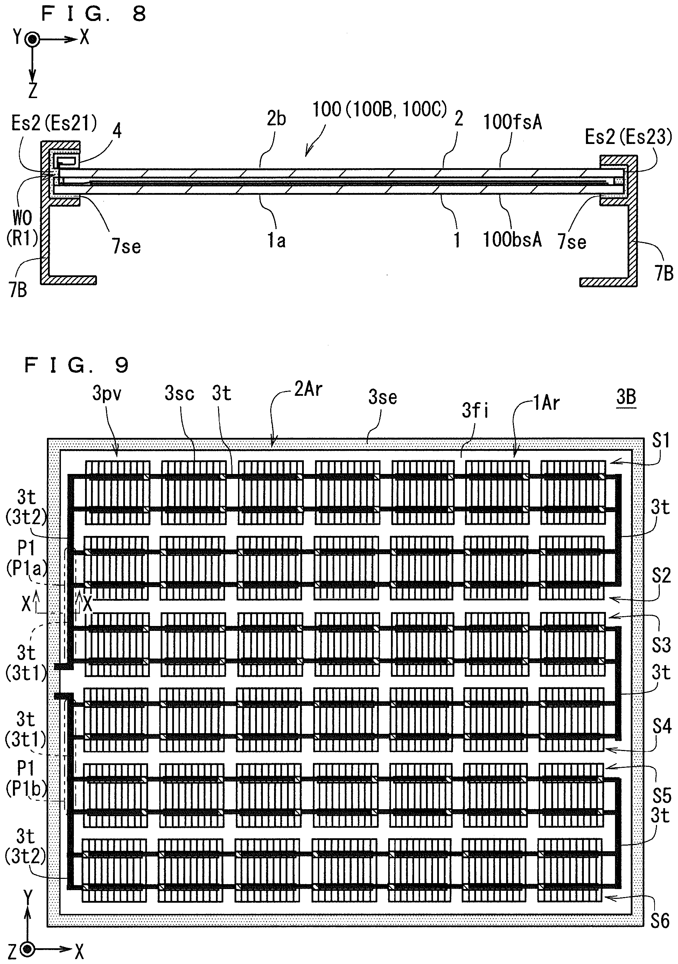

In the first embodiment described above, for example, as shown in Fig. 8, the fourth face 2b on the -Z direction side of the second plate part 2 may be a front surface 100fsA to be mainly irradiated with external light such as sunlight, and the first face 1a on the +Z direction side of the first plate part 1 may be a back surface 100bsA. At this time, it suffices that the second plate part 2 has a light-transmitting property for light having a wavelength in the specific range. Further, at this time, the first plate part 1 may have a light-transmitting property for light having a wavelength in the specific range, or may not have a light-transmitting property to light having a wavelength in the specific range. In other words, in the first embodiment and a second embodiment, it suffices that at least one of the first plate part 1 and the second plate part 2 has a light-transmitting property for light having a wavelength in the specific range. Further, in the second embodiment, for example, as shown in Fig. 8, a terminal box 4 may be positioned on the front surface 100fsA. Then, for example, as shown in Fig. 8, along four sides of an end face of a solar cell module 100, a frame 7B having such a shape as the frame 7 described above, which is turned upside down with an XY plane as a reference, may be positioned.

### <2-2. Third Embodiment>

In the first embodiment and the second embodiment described above, for example, in a region close to the third opening Op3 of the gap 3g, two or more wiring materials 3t may be positioned in a state of being aligned in the +Z direction as the thickness direction of the first plate part 1. In other words, for example, in a region that is present between the third opening Op3 and the solar cell section 3pv in plan perspective view of the solar cell module 100 in the thickness direction (+Z direction) of the first plate part 1, two or more wiring materials 3t may be positioned so as to be aligned in the thickness direction (+Z direction) of the first plate part 1.

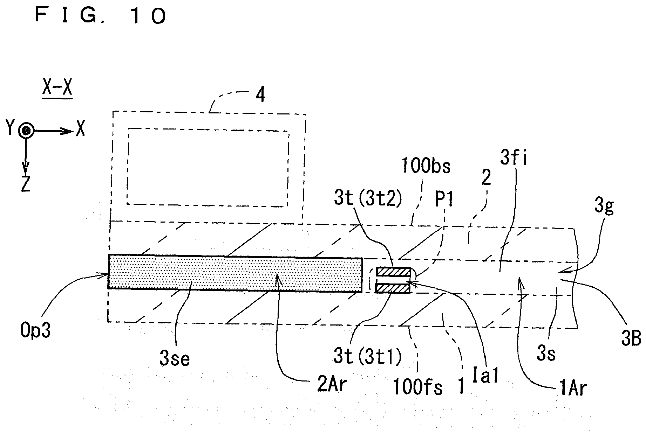

A configuration of a solar cell module 100B according to a third embodiment will be described with reference to Figs. 9 and 10. For example, the solar cell module 100B is obtained by, with the solar cell module 100 according to the first embodiment and the second embodiment described above as a basic structure, replacing the protected part 3 with a protected part 3B.

The protected part 3B includes, for example, a solar cell section 3pv including N pieces of solar cell element 3sc. In the example of Fig. 9, the solar cell element 3sc is a crystalline solar cell element. Specifically, 42 pieces of solar cell element 3sc are electrically connected in series by a wiring material 3t. Here, for example, a first solar cell group S1, a second solar cell group S2, a third solar cell group S3, a fourth solar cell group S4, a fifth solar cell group S5, and a sixth solar cell group S6, each of which includes seven pieces of solar cell element 3sc aligned in the +X direction and electrically connected in series, are further electrically connected in series in this described order.

Here, a plurality of wiring materials 3t of the protected part 3B include a first wiring material 3t1 and a second wiring material 3t2. Then, in a region closer to a third opening Op3 positioned at an outer peripheral edge of a gap 3g than the solar cell section 3pv in the gap 3g, there is a portion (also referred to as a parallel portion) PI where the first wiring material 3t1 and the second wiring material 3t2 are positioned in a state of being aligned with an insulation region Ia1 interposed in between, in a thickness direction (+Z direction) of a first plate part 1. Specifically, for example, there is a parallel portion P1a in which the first wiring material 3t1 positioned in a state of electrically connecting the second solar cell group S2 and the third solar cell group S3, and the second wiring material 3t2 in a state of electrically connecting the first solar cell group S1 and a terminal box 4 are positioned in a state of being aligned in the thickness direction (+Z direction) of the first plate part 1. Further, for example, there is a parallel portion P1b in which the first wiring material 3t1 positioned in a state of electrically connecting the fourth solar cell group S4 and the fifth solar cell group S5, and the second wiring material 3t2 in a state of electrically connecting the sixth solar cell group S6 and the terminal box 4 are positioned in a state of being aligned in the thickness direction (+Z direction) of the first plate part 1. In the example of Fig. 9, there are the first wiring material 3t1 and the second wiring material 3t2 in a state of being aligned such that wide surfaces are opposed to each other in each parallel portion P1a and P1b.

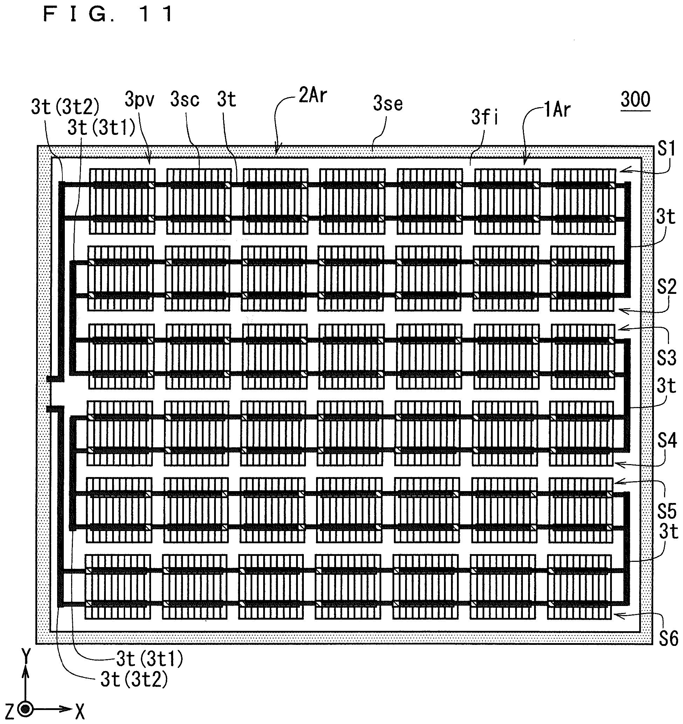

As described above, in the gap 3g, when the first wiring material 3t1 and the second wiring material 3t2 are in a state of being aligned in the thickness direction (+Z direction) in the region closer to the third opening Op3 than the solar cell section 3pv, for example, a region where the solar cell section 3pv can be arranged may be increased. Here, the example of the protected part 3B of Fig. 9 is compared with an example of a protected part 300, shown in Fig. 11, in which the first wiring material 3t1 and the second wiring material 3t2 are in a state of being aligned in a direction (here, the +X direction) along a third face 2a of a second plate part 2, instead of being aligned in the thickness direction (+Z direction). At this time, for example, in plan perspective view in the +Z direction, a ratio of an area of the solar cell section 3pv to the entire area of the protected part 3B can be made appreciably larger than a ratio of an area of the solar cell section 3pv to the entire area of the protected part 300. Therefore, the effective area of the solar cell module 100B can be increased. As a result, for example, conversion efficiency in the solar cell module 100B can be improved.

Further, in the gap 3g, when the first wiring material 3t1 and the second wiring material 3t2 are positioned in a state of being aligned in the thickness direction (+Z direction) in the region closer to the third opening Op3 than the solar cell section 3pv, for example, a path of light incident on the solar cell section 3pv is unlikely to be interrupted by the wiring material 3t. As a result, for example, the conversion efficiency in the solar cell module is unlikely to deteriorate.

Further, for example, due to the presence of the parallel portion PI in which the first wiring material 3t1 and the second wiring material 3t2 are positioned in a state of being aligned in the thickness direction, the path through which moisture may enter from the third opening Op3 on the outer peripheral edge of the gap 3g toward the solar cell section 3pv is narrowed. Here, for example, in a case where a distance between the first plate part 1 and the second plate part 2 is 1 mm, when each thickness of the first wiring material 3t1 and the second wiring material 3t2 is 400 µm, a region is generated where a portion having a room for moisture to pass through in the gap 3g is a portion having a thickness of 200 µm. Therefore, moisture is unlikely to enter from the third opening Op3 toward the solar cell section 3pv. As a result, for example, the solar cell section 3pv is unlikely to deteriorate. Therefore, for example, in the solar cell module 100B, it is possible to easily maintain high conversion efficiency for a long period of time.

The insulation region Ia1 is a region having an insulating property capable of reducing a short circuit due to contact between the first wiring material 3t1 and the second wiring material 3t2. The insulation region Ia1 may be realized by, for example, arrangement of a solid having an insulating property or a gas having an insulating property, or the like. The solid having an insulating property may be, for example, an organic material such as a resin, or may be an inorganic material such as ceramics. At this time, for example, when lamination processing is performed in a state where a solid having an insulating property is arranged in advance between the first wiring material 3t1 and the second wiring material 3t2, the insulation region Ia1 may be easily formed. Further, a gas having an insulating property may be, for example, air or the like, or may be a non-oxidizing gas including an inert gas such as nitrogen. Here, for example, when the lamination processing is performed in a state where the first wiring material 3t1 is joined in advance to the second face 1b of the first plate part 1 and the second wiring material 3t2 is joined in advance to the third face 2a of the second plate part 2, the insulation region Ia1 may be constituted by a gas having an insulating property.

Further, for example, when a sealing material (also referred to as an inner sealing material) 3s positioned inside the gap 3g is positioned in the insulation region Ia1, moisture is unlikely to enter from the third opening Op3 toward the solar cell section 3pv. This makes it difficult, for example, for the solar cell section 3pv to deteriorate. Therefore, for example, in the solar cell module 100B, it is possible to easily maintain high conversion efficiency for a long period of time.

Here, for example, in the gap 3g, the inner sealing material 3s may be in a state of being filled in a region surrounding the parallel portion PI where the first wiring material 3t1 and the second wiring material 3t2 are positioned in a state of being aligned in the thickness direction (+Z direction) of the first plate part 1. At this time, for example, in the region surrounding the parallel portion PI, a region from the second face 1b of the first plate part 1 to the third face 2a of the second plate part 2 may be in a state of being filled with the inner sealing material 3s. When such a configuration is adopted, in a path from the third opening Op3 of the gap 3g toward the solar cell section 3pv, a region around the parallel portion PI is sealed. Therefore, for example, moisture is unlikely to pass through from the third opening Op3 toward the solar cell section 3pv. This makes it difficult, for example, for the solar cell section 3pv to deteriorate. Therefore, for example, in the solar cell module 100B, it is possible to easily maintain high conversion efficiency for a long period of time.

In the examples of Figs. 9 and 10, the first region 1Ar covering the solar cell section 3pv is in a state of including the parallel portion P1. This causes the parallel portion PI to be positioned in a state of being covered with a first sealing material 3fi. In other words, in the first region 1Ar in a state of being filled with the first sealing material 3fi having a lower water barrier property than that of a second sealing material 3se, there is the parallel portion PI where the first wiring material 3t1 and the second wiring material 3t2 are positioned in a state of being aligned in the thickness direction (+Z direction) of the first plate part 1. At this time, for example, moisture is unlikely to pass through from the third opening Op3 on the outer peripheral edge of the gap 3g toward the solar cell section 3pv. This makes it difficult, for example, for the solar cell section 3pv to deteriorate. Therefore, for example, in the solar cell module 100B, it is possible to easily maintain high conversion efficiency for a long period of time.

Here, it was confirmed that, even if a structure similar to the parallel portion PI was manufactured and a high voltage of 8 kV was applied between the first wiring material 3t1 and the second wiring material 3t2, a current equal to or higher than a lower limit value (1 µA) of a current that could be detected by an ammeter did not flow between the first wiring material 3t1 and the second wiring material 3t2. Here, for example, a copper foil having a width of 2 mm, a thickness of 400 µm, and a length of 230 mm was used as the first wiring material 3t1 and the second wiring material 3t2. Then, such a state was made that the first wiring material 3t1 and the second wiring material 3t2 were arranged with an interval of 200 µm, and EVA was filled between the first wiring material 3t1 and the second wiring material 3t2.

Further, in the examples of Figs. 9 and 10, the inner sealing material 3s includes, not only the first sealing material 3fi, but also the second sealing material 3se having a higher water barrier property than that of the first sealing material 3fi. Then, this second sealing material 3se is in a state of being filled in, in the gap 3g, the annular second region 2Ar that is along the third opening Op3 and closer to the third opening Op3 than the first region 1Ar that is in a state of being filled with the first sealing material 3fi. Therefore, for example, moisture is unlikely to pass through from the opening Op3 on the outer peripheral edge of the gap 3g toward the solar cell section 3pv. This makes it difficult, for example, for the solar cell section 3pv to deteriorate. Therefore, for example, in the solar cell module 100B, it is possible to easily maintain high conversion efficiency for a long period of time.

### <2-3. Fourth Embodiment>

In the third embodiment described above, for example, the solar cell section 3pv may be changed to a tandem solar cell section 3pvC in which two or more different types of photoelectric conversion parts are positioned in a state of being stacked.

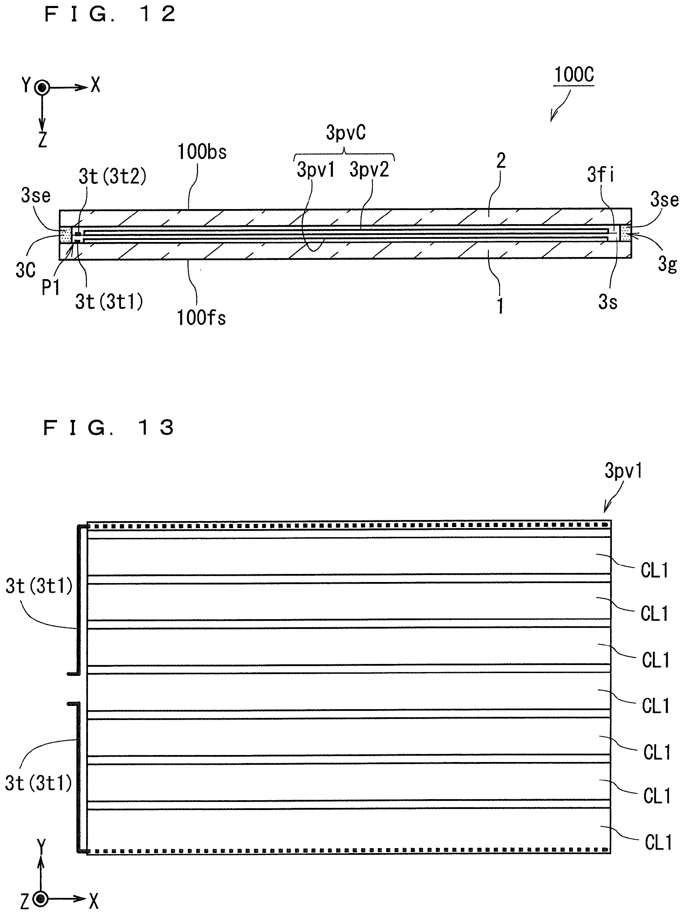

Here, a configuration of an example of a solar cell module 100C according to a fourth embodiment will be described with reference to Figs. 12 to 14. For example, the solar cell module 100C is obtained by, with the solar cell module 100B according to the third embodiment described above as a basic structure, replacing the protected part 3B with a protected part 3C. As shown in Fig. 12, the protected part 3C is obtained by, with the protected part 3B as a basic structure, replacing the solar cell section 3pv with a solar cell section 3pvC, and changing the number and positions of the wiring materials 3t.

The solar cell section 3pvC includes, for example, a first photoelectric conversion part 3pv1 and a second photoelectric conversion part 3pv2. The first photoelectric conversion part 3pv1 and the second photoelectric conversion part 3pv2 are positioned, for example, in a state of being aligned in a thickness direction (+Z direction) of a first plate part 1. In the example of Fig. 12, the first photoelectric conversion part 3pv1 and the second photoelectric conversion part 3pv2 are positioned in a state of being separated and opposed to each other.

The first photoelectric conversion part 3pv1 is positioned between a front surface 100fs on which sunlight is mainly incident, and the second photoelectric conversion part 3pv2. The second photoelectric conversion part 3pv2 is positioned between a back surface 100bs that is less irradiated with external light such as sunlight than the front surface 100fs, and the first photoelectric conversion part 3pv1. Therefore, it is sufficient that, for example, in light irradiated on the first photoelectric conversion part 3pv1, light passing through this first photoelectric conversion part 3pv1 is used for photoelectric conversion in the second photoelectric conversion part 3pv2. Here, for the first photoelectric conversion part 3pv1, for example, there is applied one in which a plurality of first solar cell elements CL1 as top cells that absorb visible light and near infrared light and utilize for photoelectric conversion are in a state of being aligned. In other words, the first photoelectric conversion part 3pv1 includes the plurality of first solar cell elements CL1. As such a first solar cell element CL1, for example, a solar cell element using a compound semiconductor such as a compound having a perovskite structure or the like is adopted. Further, at this time, for the second photoelectric conversion part 3pv2, for example, there is applied one in which a plurality of second solar cell elements CL2 as bottom cells that absorb infrared light having a longer wavelength than that of near infrared light and utilize for photoelectric conversion are in a state of being aligned. In other words, the second photoelectric conversion part 3pv2 includes a plurality of second solar cell elements CL2. As such a second solar cell element CL2, for example, a solar cell element or the like using a semiconductor made of silicon crystal is adopted. According to such a tandem solar cell section 3pvC, incident light can be effectively used to increase a power generation amount. As a result, the conversion efficiency of the solar cell module 100C may be increased.

Note that, in the example described above, a thin film semiconductor is applied as the first solar cell element CL1 and a crystalline semiconductor is applied as the second solar cell element CL2. However, as long as it functions as a tandem solar cell, the combination of the first solar cell element CL1 and the second solar cell element CL2 is not limited to the above example. For example, a crystalline semiconductor may be applied as the first solar cell element CL1 and a thin film semiconductor may be applied as the second solar cell element CL2, or mutually different kinds of thin film semiconductors may be applied to the first solar cell element CL1 and the second solar cell element CL2.

In the first photoelectric conversion part 3pv1, the plurality of first solar cell elements CL1 are positioned in a state of being aligned in a first direction along a second face 1b. In the example of Fig. 13, the first direction is the +Y direction. Further, the plurality of first solar cell elements CL1 are positioned in a state of being electrically connected in series. More specifically, in the example of Fig. 13, the first photoelectric conversion part 3pv1 is in a state where seven pieces of thin film first solar cell element CL1 are connected in series on the second face 1b of the first plate part 1. Then, two first wiring materials 3t1 are positioned in a state of being electrically connected to the first photoelectric conversion part 3pv1. These two first wiring materials 3t1 are positioned in a state of being electrically connected to terminal components 4ec in an inside 4is of a terminal box 4, and electricity can be outputted from the first photoelectric conversion part 3pv1 to the terminal box 4. Here, for example, the first wiring material 3t1 as one wiring material 3t is positioned in a state of being joined to a positive electrode of the first photoelectric conversion part 3pv1. In addition, the first wiring material 3t1 as another wiring material 3t is positioned in a state of being joined to a negative electrode of the first photoelectric conversion part 3pv1. Joining of each first wiring material 3t1 to the first photoelectric conversion part 3pv1 is performed by, for example, soldering or the like. In addition, here, for example, each first wiring material 3t1 may be arranged along a desired path by being bent appropriately. Here, each first wiring material 3t1 may be bent at a desired position, for example, before being joined to the first photoelectric conversion part 3pv1.

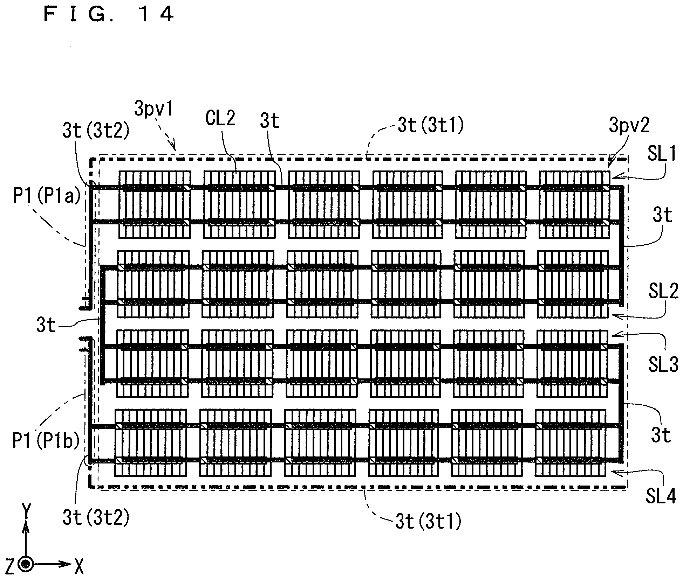

In the example of Fig. 14, in the second photoelectric conversion part 3pv2, four solar cell element groups SL1, SL2, SL3, and SL4 are positioned in a state of being electrically connected in series by the wiring material 3t. In each of the solar cell element groups SL1, SL2, SL3, and SL4, six pieces of second solar cell element CL2 aligned in the +X direction are positioned in a state of being electrically connected in series by the wiring material 3t. Then, two second wiring materials 3t2 are positioned in a state of being electrically connected to the second photoelectric conversion part 3pv2. These two second wiring materials 3t2 are positioned in a state of being electrically connected to terminal components 4ec in the inside 4is of the terminal box 4, and electricity can be outputted from the second photoelectric conversion part 3pv2 to the terminal box 4. Here, for example, the second wiring material 3t2 as one wiring material 3t is positioned in a state of being joined to the first one solar cell element group SL1. In addition, the second wiring material 3t2 as another wiring material 3t is positioned in a state of being joined to the fourth one solar cell element group SL4. Joining of the second wiring material 3t2 to the second photoelectric conversion part 3pv2 is performed by, for example, soldering or the like. In addition, here, for example, each second wiring material 3t2 may be arranged along a desired path by being bent appropriately. Here, each second wiring material 3t2 may be bent at a desired position, for example, before being joined to the second photoelectric conversion part 3pv2.

As shown in Fig. 14, the second photoelectric conversion part 3pv2 includes a plurality of solar cell element groups SL1, SL2, SL3, and SL4. Here, the plurality of solar cell element groups SL1, SL2, SL3, and SL4 include a first one solar cell element group (also referred to as a first solar cell element group) SL1, a second one solar cell element group (also referred to as a second solar cell element group) SL2, a third one solar cell element group (also referred to as a third solar cell element group) SL3, and a fourth one solar cell element group (also referred to as a fourth solar cell element group) SL4. In addition, each of the solar cell element groups SL1, SL2, SL3, and SL4 includes a plurality of second solar cell elements CL2 that are aligned along a second direction (here, +X direction) crossing the first direction (here, the +Y direction), along a third face 2a of a second plate part 2. Then, the first solar cell element group SL1 and the second solar cell element group SL2 are positioned in a state of being electrically connected in series by the wiring material 3t. The second solar cell element group SL2 and the third solar cell element group SL3 are positioned in a state of being electrically connected in series by the wiring material 3t. The third solar cell element group SL3 and the fourth solar cell element group SL4 are positioned in a state of being electrically connected in series by the wiring material 3t. In other words, the first solar cell element group SL1, the second solar cell element group SL2, the third solar cell element group SL3, and the fourth solar cell element group SL4 are positioned in a state of being electrically connected in series in this described order.

In Fig. 14, positions of the two first wiring materials 3t1 electrically connected to the first photoelectric conversion part 3pv1 in plan perspective view of the plane in the -Z direction are illustrated with a thick two-dot chain line. In the examples of Figs. 12 to 14, similarly to the third embodiment, in a region closer to a third opening Op3 positioned on the outer peripheral edge than the solar cell section 3pv in a gap 3g, there is a parallel portion PI where the first wiring material 3t1 and the second wiring material 3t2 are positioned in a state of being aligned with an insulation region Ia1 interposed in between, in a thickness direction (+Z direction) of the first plate part 1. Specifically, there is the parallel portion P1a in which the first wiring material 3t1 electrically connecting the positive electrode of the first photoelectric conversion part 3pv1 and the terminal box 4, and the second wiring material 3t2 electrically connecting the first one solar cell element group SL1 of the second photoelectric conversion part 3pv2 and the terminal box 4 are positioned in a state of being aligned in the +Z direction. Further, there is a parallel portion P1b in which the first wiring material 3t1 positioned in a state of being electrically connecting the negative electrode of the first photoelectric conversion part 3pv1 and the terminal box 4, and the second wiring material 3t2 positioned in a state of being electrically connecting the fourth one solar cell element group SL4 of the second photoelectric conversion part 3pv2 and the terminal box 4 are positioned in a state of being aligned in the +Z direction.

Here, for example, a set of one first wiring material 3t1 and one second wiring material 3t2 from the parallel portion P1a may be in a state of being connected to the terminal components 4ec of the inside 4is of the terminal box 4 via a same recess part R1. At this time, in the recess part R1, for example, an insulator such as a resin may be in a state of being sandwiched between the one first wiring material 3t1 and the one second wiring material 3t2. Further, for example, a set of one first wiring material 3t1 and one second wiring material 3t2 from the parallel portion P1b may be in a state of being connected to the terminal components 4ec of the inside 4is of the terminal box 4 via a same recess part R1. At this time, in the recess part R1, for example, it is sufficient that an insulator such as a resin is in a state of being sandwiched between the one first wiring material 3t1 and the one second wiring material 3t2.

Further, for example, one first wiring material 3t1 and one second wiring material 3t2 from the parallel portion P1a may be positioned in a state of being connected to the terminal components 4ec of the inside 4is of the terminal box 4 via different recess parts R1. Further, for example, one first wiring material 3t1 and one second wiring material 3t2 from the parallel portion P1b may be positioned in a state of being connected to the terminal components 4ec of the inside 4is of the terminal box 4 via different recess parts R1. At this time, for example, a state where four recess parts R1 are formed in the second plate part 2 is sufficient.

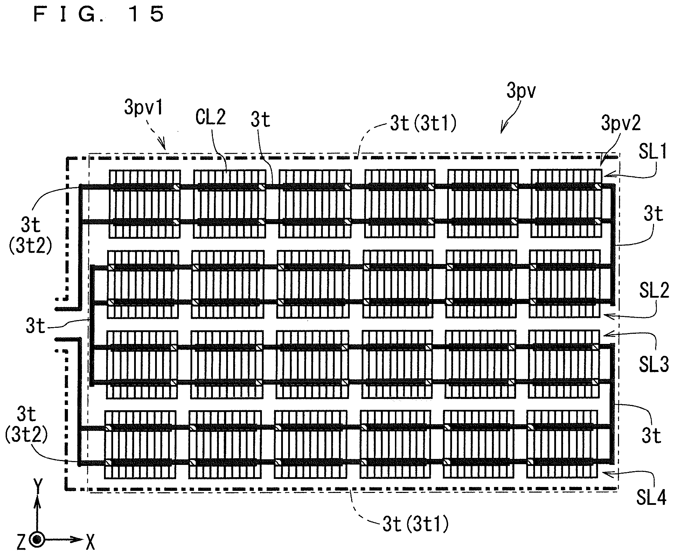

Here, an example in Fig. 14 of a state where the first wiring material 3t1 and the second wiring material 3t2 are arranged in the thickness direction is compared with an example shown in Fig. 15 of a state where the first wiring material 3t1 and the second wiring material 3t2 are aligned in a direction (here, the +X direction) along the third face 2a of the second plate part 2 instead of being aligned in the thickness direction. At this time, for example, in the gap 3g, a region required for arranging the first wiring material 3t1 and the second wiring material 3t2 becomes appreciably smaller in the example of Fig. 14 than that in the example of Fig. 15. Therefore, the effective area of the solar cell module 100C can be increased. As a result, for example, conversion efficiency in the solar cell module 100C can be improved.

Further, in the fourth embodiment, for example, the first photoelectric conversion part 3pv1 and the second photoelectric conversion part 3pv2 are in a state of being aligned in the thickness direction (+Z direction) of the first plate part 1, and the first wiring material 3t1 electrically connected to the first photoelectric conversion part 3pv1 and the second wiring material 3t2 electrically connected to the second photoelectric conversion part 3pv2 are in a state of being aligned in the thickness direction (+Z direction) of the first plate part 1. This makes it possible to easily increase the parallel portion PI in which the first wiring material 3t1 and the second wiring material 3t2 are in a state of being arranged in the thickness direction (+Z direction) of the first plate part 1. As a result, for example, in a first region 1Ar filled with a first sealing material 3fi, a water barrier property from the third opening Op3 at the outer peripheral edge of the gap 3g toward the solar cell section 3pvC may be improved. Therefore, for example, in the solar cell module 100C, it is possible to easily maintain high conversion efficiency for a long period of time.

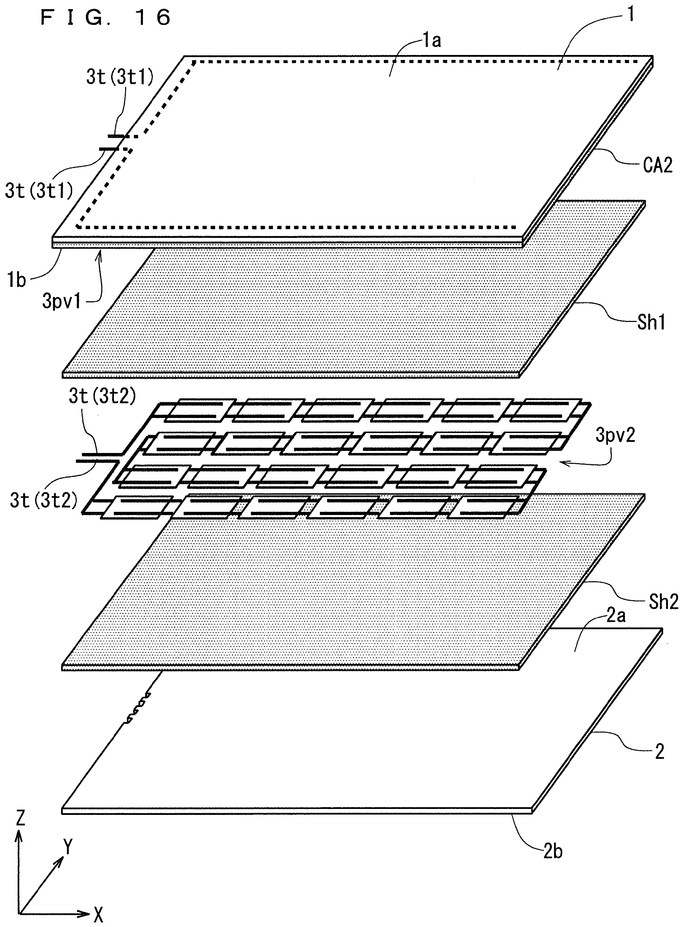

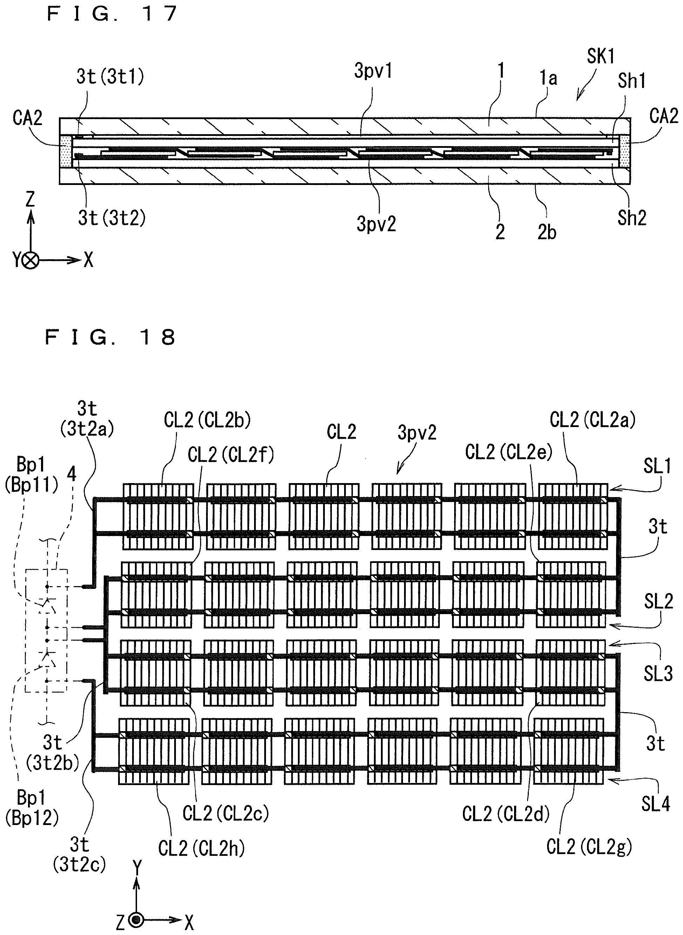

Here, one example of a method for manufacturing the solar cell module 100C according to the fourth embodiment will be described with reference to Figs. 16 and 17.

First, as shown in Fig. 16, a laminate SK1 shown in Fig. 17 is formed by stacking the first plate part 1, a first sheet Sh1, the second photoelectric conversion part 3pv2, a second sheet Sh2, and the second plate part 2. Here, on the second face 1b of the first plate part 1, the first photoelectric conversion part 3pv1 is formed in advance, and this first photoelectric conversion part 3pv1 is connected with wiring materials 3t. Further, in an annular region along an outer periphery of the second face 1b of the first plate part 1, a resin (butyl resin or the like) CA2 to be a second sealing material 3se is adhered in advance in a state of being molten by heating. In addition, the first sheet Sh1 and the second sheet Sh2 are sheets made of resin (EVA or the like) to be the first sealing material 3fi. To the second photoelectric conversion part 3pv2, the wiring materials 3t are connected in advance.

Next, the laminate SK1 is integrated by lamination processing using a laminating apparatus (laminator). Thereafter, the terminal box 4 is mounted on the fourth face 2b of the second plate part 2, and whereby the solar cell module 100C is manufactured. At this time, by appropriately mounting the frame 7 to the solar cell module 100C, the solar cell module 100C mounted with the frame 7 is completed.

In addition, here, for example, in a part of solar cell element groups among the first solar cell element group SL1 to the fourth solar cell element group SL4 that are electrically connected in series, there may be a bypass diode Bp1 so as to make it difficult for a hot spot phenomenon due to an increase of an internal resistance to occur due to an influence of a shadow or the like. The bypass diode Bp1 may simply be positioned, for example, in the terminal box 4 or the like.

In the example of Fig. 18, the plurality of second solar cell elements CL2 of the first solar cell element group SL1 include a 2A-th solar cell element CL2a connected to the second solar cell element group SL2 by the wiring material 3t, and a 2B-th solar cell element CL2b positioned on a side opposite to the 2A-th solar cell element CL2a in the second direction (+X direction). The plurality of second solar cell elements CL2 of the third solar cell element group SL3 include a 2C-th solar cell element CL2c connected to the second solar cell element group SL2 by the wiring material 3t, and a 2D-th solar cell element CL2d positioned on a side opposite to the 2C-th solar cell element CL2c in the second direction (+X direction). The plurality of second solar cell elements CL2 of the second solar cell element group SL2 include a 2E-th solar cell element CL2e connected to the first solar cell element group SL1 by the wiring material 3t, and a 2F-th solar cell element CL2f positioned on a side opposite to the 2E-th solar cell element CL2e in the second direction (+X direction). The plurality of second solar cell elements CL2 of the fourth solar cell element group SL4 include a 2G-th solar cell element CL2g connected to the third solar cell element group SL3 by the wiring material 3t, and a 2H-th solar cell element CL2h positioned on a side opposite to the 2G-th solar cell element CL2g in the second direction (+X direction).

Here, for example, a 2A-th wiring material 3t2a positioned in a state of being connected to the 2B-th solar cell element CL2b and a 2B-th wiring material 3t2b connected to the 2C-th solar cell element CL2c are in a state of being electrically connected via a first bypass diode Bp11. In this case, for example, when an internal resistance increases due to an influence of a shadow or the like in at least one second solar cell element CL2 included in the first solar cell element group SL1 and the second solar cell element group SL2, a current flows through the first bypass diode Bp11. At this time, for example, all the second solar cell elements CL2 in the first solar cell element group SL1 and the second solar cell element group SL2 are not used for power generation. As a result, in the first solar cell element group SL1 and the second solar cell element group SL2, damage to the second solar cell element CL2 due to occurrence of a hot spot phenomenon is unlikely to occur.

Here, for example, the 2B-th wiring material 3t2b positioned in a state of being connected to the 2F-th solar cell element CL2f and a 2C-th wiring material 3t2c connected to the 2H-th solar cell element CL2h are in a state of being electrically connected via a second bypass diode Bp12. In this case, for example, when an internal resistance increases due to an influence of a shadow or the like in at least one second solar cell element CL2 included in the third solar cell element group SL3 and the fourth solar cell element group SL4, a current flows through the second bypass diode Bp12. At this time, for example, all the second solar cell elements CL2 in the third solar cell element group SL3 and the fourth solar cell element group SL4 are not used for power generation. As a result, in the third solar cell element group SL3 and the fourth solar cell element group SL4, damage to the second solar cell element CL2 due to occurrence of a hot spot phenomenon is unlikely to occur.

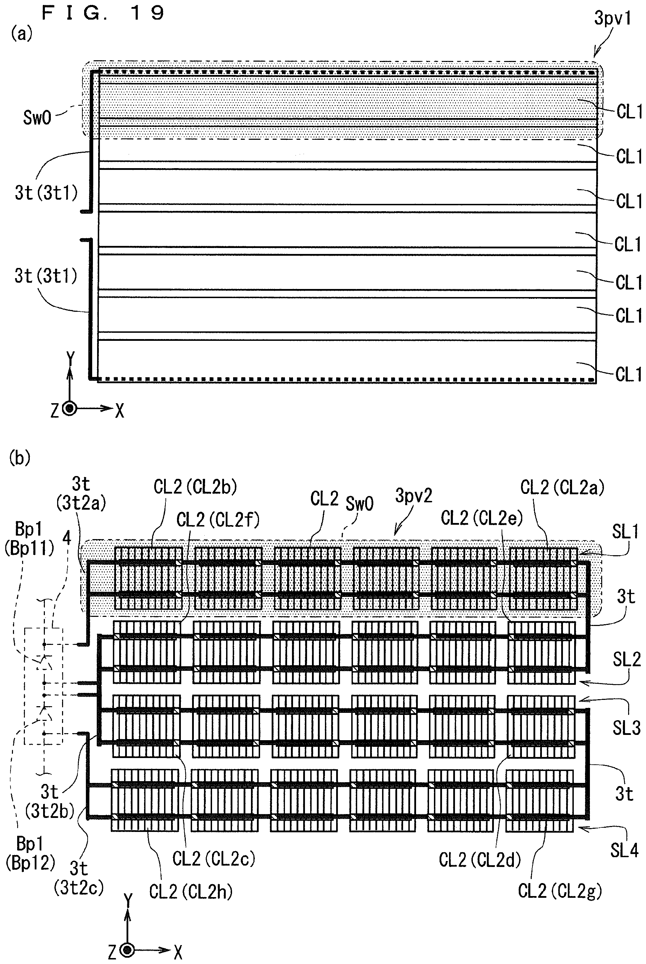

In the example of Figs. 19(a) and 19(b), the first direction (+Y direction) in which a plurality of first solar cell elements CL1 electrically connected in series in the first photoelectric conversion part 3pv1 are aligned is orthogonal to the second direction (+X direction) in which a plurality of second solar cell elements CL2 are aligned in each of the solar cell element groups SL1, SL2, SL3, and SL4 of the second photoelectric conversion part 3pv2. Here, for example, suppose a case where, as shown in Fig. 19(a), in the first photoelectric conversion part 3pv1, the entire area of one first solar cell element CL1 enters a shadow Sw0, and whereby power generation in the first photoelectric conversion part 3pv1 is no longer performed. In this case, as shown in Fig. 19(b), in the second photoelectric conversion part 3pv2, the first solar cell element group SL1 enters the shadow Sw0. At this time, in the first solar cell element group SL1 and the second solar cell element group SL2, an internal resistance increases due to an influence of the shadow Sw0, and a current flows through the first bypass diode Bp11. This allows power generation to be performed, in the second photoelectric conversion part 3pv2, in the third solar cell element group SL3 and the fourth solar cell element group SL4, which are at least a part of the plurality of solar cell element groups SL1, SL2, SL3, and SL4. Therefore, power generation is likely to be performed in at least one photoelectric conversion part of the first photoelectric conversion part 3pv1 and the second photoelectric conversion part 3pv2.

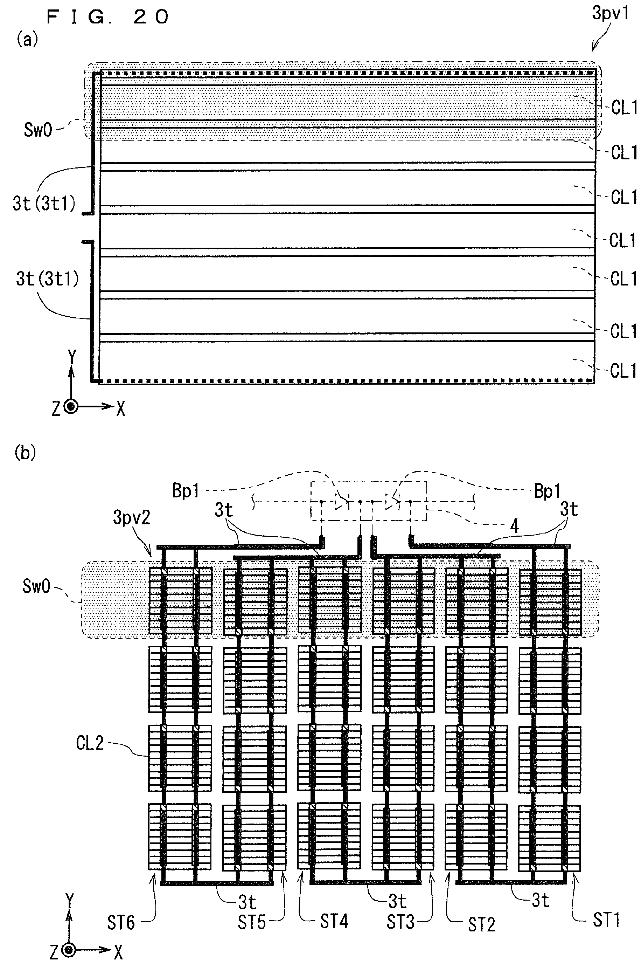

Here, suppose a case where, as shown in Figs. 20(a) and 20(b), the first direction (+Y direction) in which a plurality of first solar cell elements CL1 electrically connected in series in the first photoelectric conversion part 3pv1 are aligned is same as the second direction (+X direction) in which the second solar cell elements CL2 are aligned in each of the solar cell element groups SL1, SL2, SL3, SL4, SL5, and SL6 of the second photoelectric conversion part 3pv2. Here, for example, as shown in Fig. 20(a), in the first photoelectric conversion part 3pv1, if the entire area of one first solar cell element CL1 enters the shadow Sw0, power generation in the first photoelectric conversion part 3pv1 is no longer performed. In this case, as shown in Fig. 20(b), in the second photoelectric conversion part 3pv2, a part of the second solar cell elements CL2 of all the solar cell element groups SL1, SL2, SL3, SL4, SL5, and SL6 enters the shadow Sw0. At this time, in all the solar cell element groups SL1, SL2, SL3, SL4, SL5, and SL6, an internal resistance increases due to an influence of the shadow Sw0, a current flows through all the bypass diodes Bp1, and power generation in the second photoelectric conversion part 3pv2 is no longer performed. Therefore, a state is likely to occur where power generation is not performed in any photoelectric conversion part of the first photoelectric conversion part 3pv1 and the second photoelectric conversion part 3pv2.

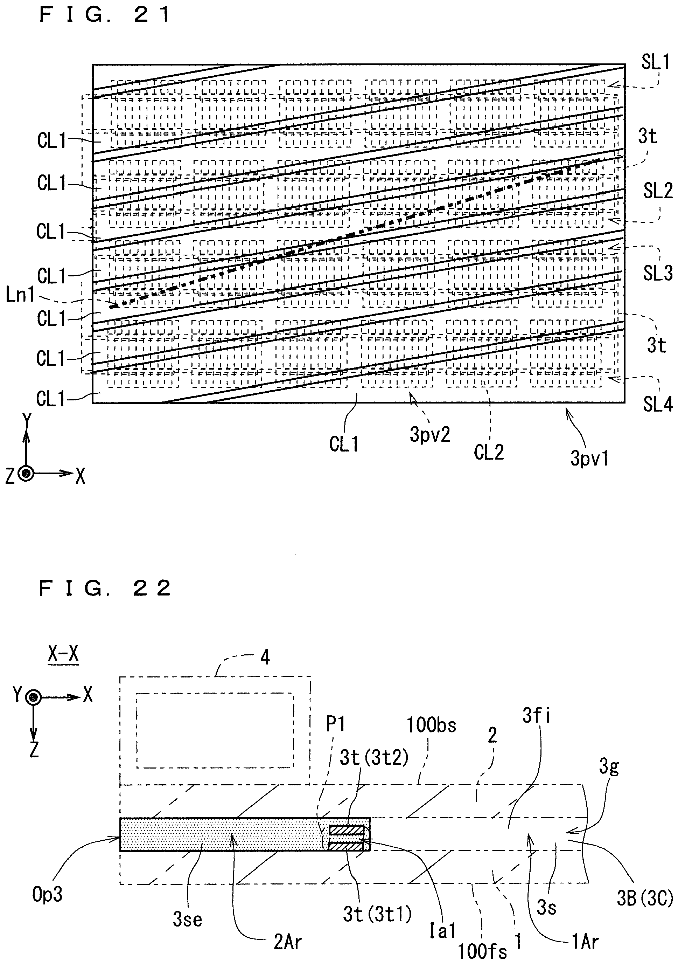

As described above, in the solar cell module 100C, the first direction (+Y direction) in which a plurality of the first solar cell elements CL1 are aligned is orthogonal to the second direction (+X direction) in which the second solar cell elements CL2 are aligned in each of the solar cell element groups SL1, SL2, SL3, and SL4. This makes it difficult for an output to decrease regardless of an influence of shadows and the like, and makes it easy for an integrated value of the power generation amount to increase. In addition, here, for example, the first direction and the second direction may not be orthogonal, but may have a relationship in which the first direction and the second direction cross each other. For example, as shown in Fig. 21, a case is considered in which an angle formed by the first direction and the second direction (+Y direction) in plan perspective view in the -Z direction is closer to a right angle than an angle formed by an extending direction of a virtual line Ln1 along a diagonal line of two adjacent solar cell element groups SL2 and SL3 and the second direction (+Y direction). In Fig. 21, the virtual line Ln1 is drawn with a thick two-dot chain line. In this case, for example, even when the entire area of one first solar cell element CL1 enters a shadow in the first photoelectric conversion part 3pv1, the second solar cell element CL2 in adjacent two solar cell element groups SL1 and SL2 or adjacent two solar cell element groups SL3 and SL4 is unlikely to enter the shadow in the second photoelectric conversion part 3pv2. However, even in a case where one first solar cell element CL1 in the first photoelectric conversion part 3pv1 enters a shadow as the first direction and the second direction become closer to being orthogonal to each other, the second solar cell element SL2 is unlikely to enter a shadow in more solar cell element groups in the second photoelectric conversion part 3pv2. Therefore, in the solar cell module 100C, regardless of the influence of a shadow or the like, power generation is likely to be performed in at least a part of the solar cell element group in the plurality of solar cell element groups SL1, SL2, SL3, and SL4, an output is unlikely to decrease, and an integrated value of the power generation amount is likely to increase.

### <2-4. Fifth Embodiment>

In the third embodiment and the fourth embodiment described above, for example, as shown in Fig. 22, the second region 2Ar may be in a state of including the parallel portion P1. In other words, for example, the parallel portion PI in which a first wiring material 3t1 and a second wiring material 3t2 are positioned in a state of being aligned in a thickness direction (+Z direction) of a first plate part 1 may also be in a state of being covered with a second sealing material 3se. At this time, the parallel portion PI is present in the second region 2Ar filled with the second sealing material 3se having a higher water barrier property than that of a first sealing material 3fi. This may improve, for example, in the second region 2Ar filled with the second sealing material 3Se, a water barrier property from a third opening Op3 toward solar cell sections 3pv and 3pvC. As a result, for example, the solar cell modules 100B and 100C are unlikely to deteriorate. In addition, for example, since the first wiring material 3t1 and the second wiring material 3t2 are positioned in a state of being aligned in the thickness direction (+Z direction) of the first plate part 1, it is possible to reduce a portion where it is difficult to spatially arrange the solar cell sections 3pv and 3pvC, and a portion where the first wiring material 3t1 and the second wiring material 3t2 become obstacles to incident light. This makes it difficult for the effective area of the solar cell modules 100B and 100C to decrease. As a result, for example, the conversion efficiency in the solar cell modules 100B and 100C is unlikely to deteriorate. Therefore, for example, in the solar cell modules 100B and 100C, it is possible to easily maintain high conversion efficiency for a long period of time.

### <2-5. Sixth Embodiment>

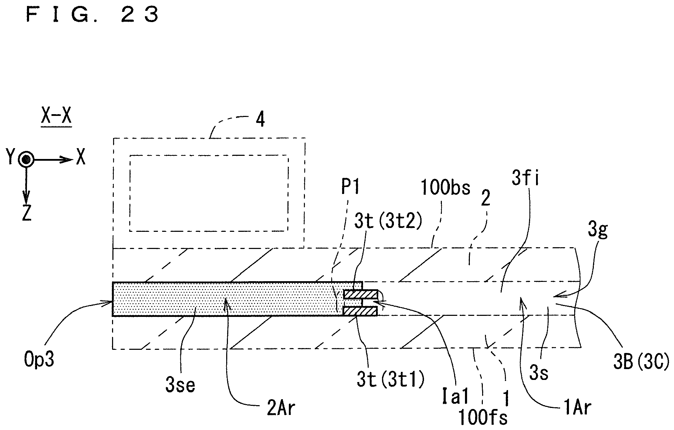

In the third embodiment and the fourth embodiment described above, for example, as shown in Fig. 23, a boundary between the first region 1Ar and the second region 2Ar may be positioned in a state of being overlapped with the parallel portion PI in which the first wiring material 3t1 and the second wiring material 3t2 are positioned in a state of being aligned in the thickness direction (+Z direction) of the first plate part 1. In other words, for example, the parallel portion PI in which the first wiring material 3t1 and the second wiring material 3t2 are positioned in a state of being aligned in the thickness direction (+Z direction) of the first plate part 1 may be present at the boundary between the first region 1Ar and the second region 2Ar. In the example of Fig. 23, a portion of a parallel portion P1 on a side close to a third opening Op3 is positioned in a state of being covered with a second sealing material 3se, and a portion of the parallel portion P1 on a side far from the third opening Op3 is positioned in a state of being covered with a first sealing material 3fir. This can realize, for example, improvement of a water barrier property in the first region 1Ar filled with the first sealing material 3fi from the third opening Op3 toward solar cell sections 3pv and 3pvC, and an increase of the effective area of the solar cell modules 100B and 100C in a well-balanced manner. Therefore, for example, in the solar cell modules 100B and 100C, it is possible to easily maintain high conversion efficiency for a long period of time.

### <2-6. Seventh Embodiment>

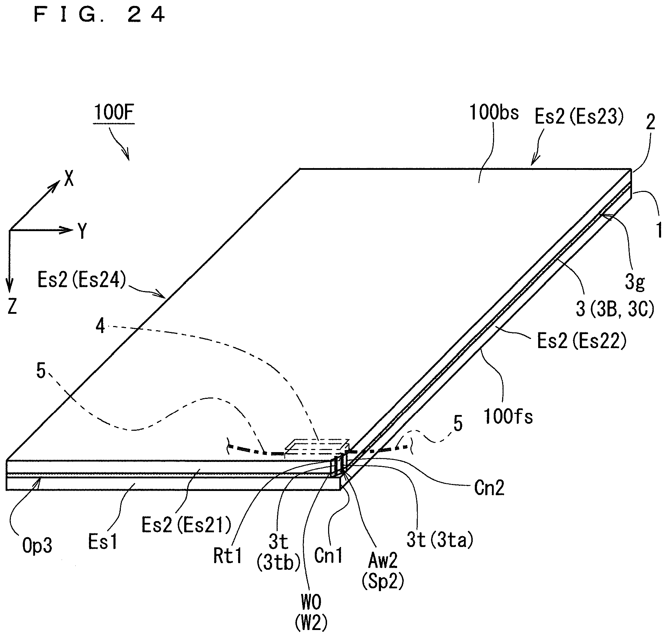

In each of the embodiments described above, for example, as shown in Figs. 24 to 26, as an example of the cutout part W0, a corner-cutout part W2 may be employed instead of the recess part R1. The corner-cutout part W2 is a portion positioned in a state of, with a first corner part Cn1 of a first plate part 1 as a reference, being cut out in a second corner part Cn2 of a second plate part 2 in plan view of the second plate part 2. The first corner part Cn1 and the second corner part Cn2 are positioned so as to overlap in the +Z direction. In other words, in plan view of the second corner part Cn2, the corner-cutout part W2 is a portion positioned closer to a center side of a second substrate 2 than an edge part of the first corner part Cn1 among the edge parts of the second corner part Cn2. Then, here, for example, a solar cell module 100F is adopted in which a wiring material 3t is positioned from the inside of a gap 3g to the outside of the gap 3g along the corner-cutout part W2 of the second plate part 2. In addition, here, for example, in plan perspective view of the first plate part 1 and the second plate part 2, a region Aw2 is positioned between the first corner part Cn1 and the second corner part Cn2. Then, the wiring material 3t is positioned from the inside of the gap 3g to the outside of the gap 3g so as to pass through a path Rt1 that is from a third face 2a side to a portion on a fourth face 2b side of a space (cutout space) Sp2 positioned along the corner-cutout part W0 in this region Aw2.

Even in adopting such a configuration, similarly to the first embodiment described above, for example, without shifting an end part of the first plate part 1 and an end part of the second plate part 2, the wiring material 3t can be arranged from the gap 3g to the region on a side opposite to the gap 3g with the second plate part 2 interposed in between. This allows, for example, a frame 7 or a stand to hold a portion of the solar cell module 100F along an end part including the corner-cutout part W2 from which the wiring material 3t is drawn out from the inside of the gap 3g to the outside of the gap 3g, so as to sandwich the first plate part 1 and the second plate part 2. As a result, for example, the strength of the solar cell module 100F is unlikely to deteriorate. Further, for example, without shifting the end part of the first plate part 1 and the end part of the second plate part 2 in order to form a region where a terminal box 4 is arranged on the second face 1b of the first plate part 1 opposed to the second plate part 2, the wiring material 3t can be arranged from the gap 3g to a region on a side opposite to the gap 3g with the second plate part 2 interposed in between. This makes it difficult for the effective area of the solar cell module 100F to decrease. As a result, for example, the conversion efficiency of the solar cell module 100F is unlikely to deteriorate. Further, for example, without providing a through hole for insertion of the wiring material 3t through the second plate part 2, the wiring material 3t can be arranged from the gap 3g to the region on a side opposite to the gap 3g with the second plate part 2 interposed in between. As a result, for example, entry of moisture from the outside of the solar cell module 100F toward the solar cell section 3pv is reduced. Therefore, according to the solar cell module 100F, high conversion efficiency may be easily maintained for a long period of time.

Here, the corner-cutout part W2 of the second plate part 2 may be formed, for example, by cutting off a part of the second corner part Cn2 of the second plate part 2 having a flat plate shape. Therefore, for example, it is possible to easily manufacture the second plate part 2 including the corner-cutout part W2. Further, since the corner-cutout part W2 can be formed by simple processing, damage due to processing in the second plate part 2 may be reduced. For this reason, for example, the strength of the second plate part 2 is unlikely to deteriorate. As a result, according to the solar cell module 100F, high conversion efficiency may be more easily maintained for a long period of time.

Here, for example, the terminal box 4 may be positioned so as to cover at least a part on the fourth face 2b side of the cutout space Sp2, on the fourth face 2b as the back surface 100bs on a side opposite to the first plate part 1, on the second plate part 2. Here, similarly to each of the embodiments described above, it suffices that the wiring materials 3t are positioned from the inside of the gap 3g to an inside of the terminal box 4 so as to pass through the path Rt1, and positioned in a state of being electrically connected to the terminal components 4ec inside the terminal box 4. At this time, for example, when the wiring material 3t is positioned from the gap 3g between the first plate part 1 and the second plate part 2 so as to reach the inside of the terminal box 4 immediately after passing through the cutout space Sp2, the wiring material 3t is unlikely to be exposed to outside air, and deterioration of the wiring material 3t is unlikely to occur. As a result, for example, the number of a special member such as a moisture-proof sheet to cover the wiring material 3t is unlikely to increase, and an increase in manufacturing cost of the solar cell module 100F due to an increase of a consumption of resources may be reduced. Therefore, for example, according to the solar cell module 100F, high conversion efficiency may be easily maintained for a long period of time.

Further, here, similarly to each of the embodiments described above, the solar cell module 100F includes a first sealing material 3fi and a second sealing material 3se in the gap 3g. The first sealing material 3fi is positioned so as to cover the solar cell section 3pv (3pvC). The second sealing material 3se is positioned around the first sealing material 3fi in plan perspective view of the second plate part 2. The second sealing material 3se has a higher water barrier property than that of the first sealing material 3fi. In other words, moisture permeability of the second sealing material 3se is lower than moisture permeability of the first sealing material 3fi.

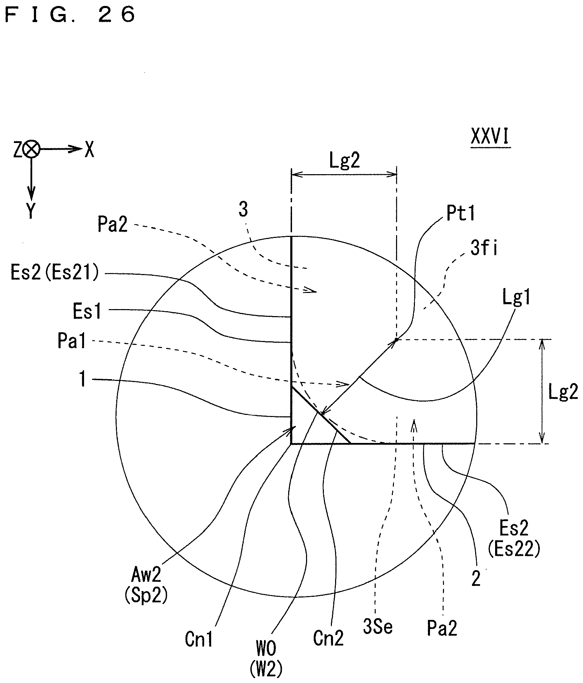

Here, for example, as shown in Fig. 26, in plan perspective view of the second plate part 2, in a first portion Pa1 positioned along the corner-cutout part Cn2 of the second plate part 2 of the second sealing material 3se, a shortest distance from an edge part of an outer edge part side of the second plate part 2 to an edge part of the first sealing material 3fi side is defined as a first existing distance Lg1. Further, for example, in plan perspective view of the second plate part 2, in a second portion Pa2 positioned next to the first portion Pa1 of the second sealing material 3Se, a shortest distance from an edge part of an outer edge part side of the second plate part 2 to an edge part of the first sealing material 3fi side is defined as a second existing distance Lg2. In the example of Fig. 26, there are two second portions Pa2 so as to sandwich the first portion Pa1. Here, for example, as long as a relationship that the first existing distance Lg1 is equal to or larger than the second existing distance Lg2 is secured, moisture is unlikely to enter from the outside of the solar cell module 100F toward the solar cell section 3pv regardless of the existence of the corner-cutout part W2. Therefore, in the solar cell module 100F, high conversion efficiency may be easily maintained for a long period of time.

Here, for example, as shown in Fig. 26, a case is considered in which, in plan perspective view of the second plate part 2 and the second sealing material 3Se, the corner-cutout part W2 is positioned outside an arc-shaped virtual line centered on a corner part Pt1 of an inner edge part of the first sealing material 3fi side in a region where the second sealing material 3Se is provided. In Fig. 26, the arc-shaped virtual line is drawn with a two-dot chain line. In this case, for example, the first existing distance Lg1 can be made equal to or larger than the second existing distance Lg2, without increasing an existing range of the second sealing material 3Se in the gap 3g. This makes it difficult for the effective area of the solar cell module 100F to decrease. As a result, for example, the conversion efficiency of the solar cell module 100F is unlikely to deteriorate.

Even in a case of adopting the above configuration, as shown in Fig. 5, the first end face Es21, the second end face Es22, the third end face Es23, and the fourth end face Es24 of the solar cell module 100F may be in a state of being mounted with, for example, a frame made of aluminum or the like. At this time, when an outer sealing material is in a state of being filled between the frame 7, and the first end face Es21, the second end face Es22, the third end face Es23, and the fourth end face Es24, moisture and the like are unlikely to enter the solar cell section 3pv from the first end face Es21, the second end face Es22, the third end face Es23, and the fourth end face Es24 of the solar cell module 100F. As a result, long-term reliability of the solar cell module 100F may be enhanced. Further, at this time, for example, when the outer sealing material is positioned so as to cover the wiring material 3t in the cutout space Sp2 along the corner-cutout part W2 as an example of the cutout part W0, the wiring material 3t is brought into a state of being sealed in the cutout space Spt along the corner-cutout part W2. This makes it difficult, for example, for the wiring material 3t to be exposed to outside air, and for the wiring material 3t to deteriorate. Therefore, for example, in the solar cell module 100F, high conversion efficiency may be easily maintained for a long period of time.

### <3. Other>

In the first embodiment to the sixth embodiment described above, for example, at least one wiring material 3t among the plurality of wiring materials 3t may also be positioned from the inside of the gap 3g to the outside of the gap 3g along the recess part R1 as an example of the cutout part W0. In this case, for example, at least one wiring material 3t among the plurality of wiring materials 3t may also be positioned from the inside of the gap 3g to the outside of the gap 3g so as to pass through the path Rt1 that is from the first opening 0p1 to the second opening Op2 in the space (cutout space) inside the recess part R1. Further, in the seventh embodiment described above, for example, at least one wiring material 3t of the plurality of wiring materials 3t may be positioned from the inside of the gap 3g to the outside of the gap 3g along the corner-cutout part W2 as an example of the cutout part W0. Therefore, for example, at least one wiring material 3t among the plurality of wiring materials 3t may be positioned from the inside of the gap 3g to the outside of the gap 3g along the cutout part W0 including at least a portion of one of the recess part R1 and the corner-cutout part W2.

In the first embodiment to the sixth embodiment described above, for example, the recess part R1 may be present so as to extend along a direction inclined with respect to the thickness direction (+Z direction) of the second plate part 2.

In the first embodiment to the sixth embodiment described above, for example, one or more recess parts R1 may be present in each of two or more side face parts Es2 of the second plate part 2. Further, in the seventh embodiment described above, for example, the corner-cutout part W2 may be present in each of two or more corner parts of the second plate part 2.

In each of the embodiments described above, for example, in the gap 3g, only the first sealing material 3fi out of the first sealing material 3fi and the second sealing material 3se may be present, or only the second sealing material 3se may be present.

In each of the embodiments described above, for example, a shape of outer edges of the first face 1a, the second face 1b, the third face 2a, and the fourth face 2b may be a quadrangle other than a rectangle, such as a lozenge and a parallelogram, or may be a polygon other than a quadrangle, such as a triangle and a hexagon. Further, in the first embodiment to the sixth embodiment described above, for example, a shape of the outer edges of the first face 1a, the second face 1b, the third face 2a, and the fourth face 2b may be a curve such as a circle or an ellipse.

In the first embodiment to the sixth embodiment described above, for example, one terminal box 4 may be positioned for one recess part R1, or one terminal box 4 may be positioned for two or more recess part R1. Further, in the seventh embodiment described above, for example, one terminal box 4 may be positioned for one corner-cutout part W2, or one terminal box 4 may be positioned for two or more corner-cutout parts W2.

Further, in the fourth embodiment described above, for example, there may be a dummy wiring material 3t so as to be aligned in the thickness direction (+Z direction) of the first plate part 1, with respect to the wiring material 3t connecting the first solar cell element group SL1 and the second solar cell element group SL2, and the wiring material 3t connecting the third solar cell element group SL3 and the fourth solar cell element group SL4. This also enables, for example, in addition to improvement of a water barrier property toward the solar cell section 3pvC from the third opening Op3 on the -X direction side, improvement of a water barrier property toward the solar cell section 3pvC from the third opening Op3 on the +X direction side.

Needless to say that all or part constituting each of the embodiments described above and each of the modified examples can be combined as appropriate in a range not inconsistent.

### Explanation of Reference Signs

1: first plate part
1a: first face
1b: second face
1Ar: first region
2: second plate part
2a: third face
2b: fourth face
2Ar: second region
3, 3B, 3C, 300: protected part
3g: gap
3pv, 3pvC: solar cell section
3pv1: first photoelectric conversion part
3pv2: second photoelectric conversion part
3s: inner sealing material
3fi: first sealing material
3se: second sealing material
3t: wiring material
3t1: first wiring material
3t2, 3t2a, 3t2b, 3t2c: second wiring material
4: terminal box
4ec: terminal component
4is: inside
7se: outer sealing material
100, 100B, 100C, 100F: solar cell module
Aw2: region
Bp1: bypass diode
Bp1 1: first bypass diode
Bp12: second bypass diode
Cn1: first corner part
Cn2: second corner part
CL1: first solar cell element
CL2: second solar cell element
CL2a: 2A-th solar cell element
CL2b: 2B-th solar cell element
CL2c: 2C-th solar cell element
CL2d: 2D-th solar cell element
CL2e: 2E-th solar cell element
CL2f: 2F-th solar cell element
CL2g: 2G-th solar cell element
CL2h: 2H-th solar cell element
Es2: side face part
Lg1: first existing distance
Lg2: second existing distance
Op1: first opening
Op2: second opening
Op3: third opening
P1, P1a, P1b: parallel portion
Pa1: first portion
Pa2: second portion
Rt1: path
SL1: first solar cell element group
SL2: second solar cell element group
SL3: third solar cell element group
SL4: fourth solar cell element group
Sp2: cutout space
W0: cutout part
W2: corner-cutout part

## Claims

1. A solar cell module comprising:
a first plate part having a first face and a second face positioned in a state of facing a direction opposite to the first face;
a second plate part having a third face positioned in a state of being opposed to the second face, and a fourth face positioned in a state of facing a direction opposite to the third face;
a solar cell section positioned in a gap between the first plate part and the second plate part; and
a plurality of wiring materials positioned in a state of being electrically connected to the solar cell section, wherein
at least one of the first plate part and the second plate part has a light-transmitting property for light having a wavelength in a specific range, and
at least one wiring material of the plurality of wiring materials is positioned from an inside of the gap to an outside of the gap, along a cutout part that is cut out in a part along one side of the second plate part with the first plate part as a reference, in plan view of the second plate part.

2. The solar cell module according to claim 1, wherein
the second plate part includes a side face part positioned in a state of connecting the third face and the fourth face,
the cutout part includes a recess part being recessed in a direction along the third face in the side face part and having a first opening on the third face side and a second opening on the fourth face side, and
the at least one wiring material is positioned from an inside of the gap to an outside of the gap to pass through a path from the first opening to the second opening in a cutout space positioned inside the recess part.

3. The solar cell module according to claim 2, comprising a terminal box positioned on the fourth face to cover at least a part of the second opening, wherein
the at least one wiring material is positioned from an inside of the gap to an inside of the terminal box to pass through the path, and is positioned in a state of being electrically connected to a terminal component inside the terminal box.

4. The solar cell module according to claim 1, wherein
the cutout part includes a corner-cutout part that is positioned in a state of, with a first corner part of the first plate part as a reference, being cut out in a second corner part of the second plate part in plan view of the second plate part, and
the at least one wiring material is positioned from an inside of the gap to an outside of the gap to pass through a path to a portion on the fourth face side from a portion on the third face side of a cutout space positioned along the corner-cutout part, in a region positioned between the first corner part and the second corner part in plan perspective view of the first plate part and the second plate part.

5. The solar cell module according to claim 4, comprising a terminal box positioned on the fourth face to cover at least a part of the fourth face side of the cutout space, wherein
the at least one wiring material is positioned from an inside of the gap to an inside of the terminal box to pass through the path, and is positioned in a state of being electrically connected to a terminal component inside the terminal box.

6. The solar cell module according to claim 4 or 5, further comprising:
a first sealing material positioned in the gap to cover the solar cell section; and
a second sealing material positioned around the first sealing material in plan perspective view of the second plate part, the second sealing material having a higher water barrier property than that of the first sealing material, wherein
in plan perspective view of the second plate part, a first existing distance from an edge part of an outer edge part side of the second plate part to an edge part of the first sealing material side in a first portion positioned along the corner-cutout part in the second sealing material, is equal to or larger than a second existing distance from an edge part of an outer edge part side of the second plate part to an edge part of the first sealing material side in a second portion positioned next to the first portion in the second sealing material.

7. The solar cell module according to any one of claims 2 to 5, comprising an outer sealing material positioned to cover the at least one wiring material in the cutout space.

8. The solar cell module according to any one of claims 1 to 5 and 7, wherein
the plurality of wiring materials include a first wiring material and a second wiring material, and
the gap has a third opening positioned at an outer peripheral edge, and includes a portion in which, in a region closer to the third opening than the solar cell section in the gap, the first wiring material and the second wiring material are positioned in a state of being aligned with an insulation region interposed in between, in a thickness direction of the first plate part.

9. The solar cell module according to claim 8, comprising an inner sealing material positioned in the insulation region.

10. The solar cell module according to claim 9, wherein the inner sealing material is, in the gap, in a state of being filled in a region surrounding a portion in which the first wiring material and the second wiring material are positioned in a state of being aligned in the thickness direction.

11. The solar cell module according to claim 10, wherein
the inner sealing material includes a first sealing material, and a second sealing material having a higher water barrier property than that of the first sealing material,
the first sealing material is in a state of being filled in a first region covering the solar cell section in the gap, and
the second sealing material is in a state of being filled in a second region having an annular shape along the third opening, the second region being closer to the third opening than the first region in the gap.

12. The solar cell module according to claim 11, wherein the first region includes a portion in which the first wiring material and the second wiring material are positioned in a state of being aligned in the thickness direction.

13. The solar cell module according to claim 11, wherein the second region includes a portion in which the first wiring material and the second wiring material are positioned in a state of being aligned in the thickness direction.

14. The solar cell module according to claim 11, wherein a boundary between the first region and the second region is in a state of being overlapped with a portion in which the first wiring material and the second wiring material are positioned in a state of being aligned in the thickness direction.

15. The solar cell module according to any one of claims 8 to 14, wherein
the solar cell section includes a first photoelectric conversion part, and a second photoelectric conversion part positioned in a state of being aligned with the first photoelectric conversion part in the thickness direction,
the first wiring material is positioned in a state of being electrically connected to the first photoelectric conversion part, and
the second wiring material is positioned in a state of being electrically connected to the second photoelectric conversion part.

16. The solar cell module according to claim 15, wherein
the first photoelectric conversion part includes a plurality of first solar cell elements positioned in a state of being aligned in a first direction along the second face and being electrically connected in series,
the second photoelectric conversion part includes a plurality of solar cell element groups each including a plurality of second solar cell elements positioned in a state of being aligned in a second direction crossing the first direction along the third face and of being electrically connected in series, the plurality of solar cell element groups being positioned in a state of being aligned along the first direction,
the plurality of solar cell element groups include a first solar cell element group and a second solar cell element group positioned in a state of being electrically connected in series, and a third solar cell element group positioned in a state of being electrically connected in series with the second solar cell element group,
the plurality of second solar cell elements included in the first solar cell element group include a 2A-th solar cell element connected to the second solar cell element group by a wiring material, and a 2B-th solar cell element positioned on a side opposite to the 2A-th solar cell element in the second direction,
the plurality of second solar cell elements included in the third solar cell element group include a 2C-th solar cell element connected to the second solar cell element group by a wiring material, and a 2D-th solar cell element positioned on a side opposite to the 2C-th solar cell element in the second direction, and
a wiring material positioned in a state of being connected to the 2B-th solar cell element and a wiring material connected to the 2C-th solar cell element are in a state of being electrically connected via a bypass diode.

17. A solar cell module comprising:
a first plate part having a first face and a second face positioned in a state of facing a direction opposite to the first face;
a second plate part having a third face positioned in a state of being opposed to the second face, and a fourth face positioned in a state of facing a direction opposite to the third face; and
a solar cell section positioned in a gap between the first plate part and the second plate part, wherein
at least one of the first plate part and the second plate part has a light-transmitting property for light having a wavelength in a specific range,
the solar cell section includes a first photoelectric conversion part, and a second photoelectric conversion part positioned in a state of being aligned with the first photoelectric conversion part in a thickness direction of the first plate part,
the first photoelectric conversion part includes a plurality of first solar cell elements positioned in a state of being aligned in a first direction along the second face and being electrically connected in series,
the second photoelectric conversion part includes a plurality of solar cell element groups each including a plurality of second solar cell elements positioned in a state of being aligned in a second direction crossing the first direction along the third face and of being electrically connected in series, the plurality of solar cell element groups being positioned in a state of being aligned along the first direction,
the plurality of solar cell element groups include a first solar cell element group and a second solar cell element group positioned in a state of being electrically connected in series, and a third solar cell element group positioned in a state of being electrically connected in series with the second solar cell element group,
the plurality of second solar cell elements included in the first solar cell element group include a 2A-th solar cell element connected to the second solar cell element group by a wiring material, and a 2B-th solar cell element positioned on a side opposite to the 2A-th solar cell element in the second direction,
the plurality of second solar cell elements included in the third solar cell element group include a 2C-th solar cell element connected to the second solar cell element group by a wiring material, and a 2D-th solar cell element positioned on a side opposite to the 2C-th solar cell element in the second direction, and
a wiring material positioned in a state of being connected to the 2B-th solar cell element and a wiring material connected to the 2C-th solar cell element are electrically connected via a bypass diode.

18. The solar cell module according to claim 16 or 17, wherein the first direction is perpendicular to the second direction.
